(19) Europäisches Patentamt
European Patent Office
Office européen des brevets

(11) EP 2 333 842 A1

(12) # EUROPEAN PATENT APPLICATION
published in accordance with Art. 153(4) EPC

(43) Date of publication:
**15.06.2011 Bulletin 2011/24**

(21) Application number: **09817907.0**

(22) Date of filing: **02.10.2009**

(51) Int Cl.:
***H01L 31/042*** *(2006.01)*

(86) International application number:
**PCT/JP2009/067268**

(87) International publication number:
**WO 2010/038875 (08.04.2010 Gazette 2010/14)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **03.10.2008 JP 2008258984**
**03.10.2008 JP 2008258985**

(71) Applicant: **Techno Polymer Co., Ltd.**
**Minato-ku**
**Tokyo 105-0021 (JP)**

(72) Inventors:
- **WATANABE Atsushi**
**Tokyo 105-0021 (JP)**
- **HASHIMOTO Masanori**
**Tokyo 105-0021 (JP)**

(74) Representative: **TBK**
**Bavariaring 4-6**
**80336 München (DE)**

(54) **SOLAR CELL BACK SURFACE PROTECTIVE FILM, AND SOLAR CELL MODULE PROVIDED WITH SAME**

(57) The back surface protective film for solar cell of the present invention is provided with a first resin layer obtained using a first thermoplastic resin composition which is prepared by melt-kneading a starting composition containing a first thermoplastic resin and a silane coupling agent. The back surface protective film may be provided with other resin layer bonding to the first resin layer. The thickness thereof is preferably in the range from 10 to 1,000 μm. The solar cell module of the present invention is provided with the back surface protective film for solar cell.

FIG. 1

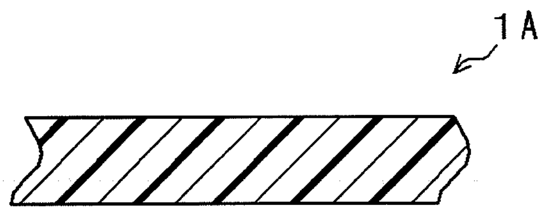


EP 2 333 842 A1

## Description

[Technical Field]

The present invention relates to a back surface protective film for solar cell and a solar cell module having the same. More particularly, the invention relates to a back surface protective film for solar cell which is excellent in adhesiveness to a filling unit of a solar cell module, the filling unit including an ethylene vinyl acetate copolymer composition or the like, and to a solar cell module which is obtained using the same.

[Background Art]

Recently, a solar light power generation system has been widely used which is provided with a solar cell module, as a type of power generating means configured to utilize clean energies. The solar cell module is configured: to include numerous plate-like solar cell elements arranged to be mutually serially or parallelly wired; and to be packaged into a unit so as to protect the elements. Further, such a solar cell module is typically structured to have a surface on which a solar light impinges and which is covered by a glass plate, in an exemplary manner that gaps around solar cell elements are filled with a composition containing an ethylene vinyl acetate copolymer or the like which is high in transparency and excellent in moisture resistance to thereby form a filling unit; and then a back surface, i.e., an exposed surface of the filling unit, is sealed by a protective film of a resin material.

As a back surface protective film for solar cell, a film containing a fluororesin, polyethylene-based resin, polyester-based resin or the like have been conventionally known, however, the film has not been sufficient in adhesiveness to a filling unit and in long-term durability. As such, adhesion enhanced type films have been investigated, each having a base layer film provided with an adhesive layer at one surface side of the film.

Patent Document 1 discloses a back surface sealing film for solar cell in which a thermal adhesive layer containing a styrene-olefin copolymer having a thermal adhesiveness to a polyolefin-based resin such as ethylene vinyl acetate copolymer is formed on a base film consisting of a polyethylene terephthalate.

Patent Document 2 discloses a film in which a coating layer containing a polyurethane-based resin or an organosilane compound is formed on a base film consisting of a polyethylene terephthalate.

Moreover, Patent Document 3 discloses a polyester film containing ethylene terephthalate unit, and a back surface protective polyester film for solar cell in which a coating film formed using a coating material containing a crosslinking agent, and a polyester resin, acrylic resin, or the like having a glass transition point of 20°C to 100°C, is provided.

[Prior Art Documents]

[Patent Document]

Patent Document 1: JP-A 2003-60218
Patent Document 2: JP-A 2006-175764
Patent Document 3: JP-A 2007-268710

[Brief Description of the Invention]

[Problems to be solved by the Invention]

In the case of a film provided with an adhesive layer as described in Patent Documents 1 to 3, it is possible to obtain a certain adhesiveness to a filling unit containing an ethylene vinyl acetate copolymer composition or the like. However, it is required to separately provide a process for forming the adhesive layer, occasionally resulting in occurrence of defects due to a coating irregularity or the like, so that protection of the filling unit has not been necessarily satisfied.

It is an object of the present invention to provide a back surface protective film for solar cell without having, on its surface, an adhesive layer otherwise provided for adhesion to a filling unit which embeds solar cell elements therein, such that the back surface protective film is excellent in adhesiveness to the filling unit embedding the solar cell elements therein, heat resistance and weather resistance, and to provide a solar cell module having the same.

As mentioned above, while solar cell modules have been each configured to include duly arranged numerous solar cell elements, it has been occasional that a solar light leaks through gaps among adjacent solar cell elements toward a back surface protective film for solar cell. As such, in a solar cell module provided with solar cell elements each capable of conducting photoelectric conversion at both of obverse and reverse surfaces thereof, it has been recently

tried to provide a back surface protective film for solar cell with a reflecting function of solar light, so as to improve a power generation efficiency.
It is another object of the present invention to provide a back surface protective film for solar cell without having, on its surface, an adhesive layer otherwise provided for adhesion to a filling unit which embeds solar cell elements therein, such that the back surface protective film is excellent in adhesiveness to the filling unit embedding the solar cell elements therein, heat resistance and weather resistance, and has a resin layer excellent in reflectivity to a solar light, particularly a light having a wavelength of 400 to 1,400 nm, and to provide a solar cell module having the same.

In turn, since those members such as solar cell elements in a solar cell module are likely to be seen through a filling unit which contains an ethylene vinyl acetate copolymer composition or the like, it has been tried to provide a dark colored layer as a back surface protective film for solar cell so as to improve an external appearance of the solar cell module. However, it has been occasional that the dark colored layer absorbs a solar light leaked through gaps among solar cell elements depending on a constituent material of the dark colored layer, resulting in heat storage, thereby deteriorating a power generation efficiency.
It is a further object of the present invention to provide a back surface protective film for solar cell without having, on its surface, an adhesive layer otherwise provided for adhesion to a filling unit which embeds solar cell elements therein, such that the back surface protective film is excellent in adhesiveness to the filling unit embedding the solar cell elements therein, heat resistance and weather resistance, and has a resin layer excellent in both transmitivity of a light having a wavelength of 800 to 1,400 nm, and absorptivity of a light having a wavelength of 400 to 700 nm, and to provide a solar cell module having the same.

[Means for solving problems]

The present invention is as follows.

1. A back surface protective film for solar cell, characterized by comprising a first resin layer obtained using a first thermoplastic resin composition which is prepared by melt-kneading a starting material composition containing a first thermoplastic resin and a silane coupling agent.
2. The back surface protective film for solar cell according to 1 above, wherein the first thermoplastic resin comprises a rubber reinforced aromatic vinyl-based resin.
3. The back surface protective film for solar cell according to 1 or 2 above, wherein the back surface protective film has a reflectance to a light having a wavelength of 400 to 1,400 nm of 50% or higher when the light is irradiated to a surface of the first resin layer of the back surface protective film for solar cell.
4. The back surface protective film for solar cell according to any one of 1 to 3 above, wherein the first thermoplastic resin composition comprises further a white-based coloring agent.
5. The back surface protective film for solar cell according to 1 or 2 above, wherein the first resin layer has a transmittance of a light having a wavelength of 800 to 1,400 nm of 60% or higher, and an absorbance of a light having a wavelength of 400 to 700 nm of 60% or higher.
6. The back surface protective film for solar cell according to 1, 2 or 5 above, wherein the first thermoplastic resin composition comprises further an infrared transmissible coloring agent.
7. The back surface protective film for solar cell according to any one of 1 to 6 above, further comprising other resin layer bonding to the first resin layer.
8. The back surface protective film for solar cell according to 7 above, wherein at least one resin layer among the first resin layer and the other resin layer comprises a white-based coloring agent.
9. The back surface protective film for solar cell according to 7 above, wherein the first resin layer has a transmittance of a light having a wavelength of 800 to 1,400 nm of 60% or higher, and an absorbance of a light having a wavelength of 400 to 700 nm of 60% or higher, and wherein the back surface protective film has a reflectance to a light having a wavelength of 800 to 1,400 nm of 50% or higher when the light is irradiated to a surface of the first resin layer of the back surface protective film for solar cell.
10. The back surface protective film for solar cell according to 7 or 9 above, wherein the first resin layer comprises an infrared transmissible coloring agent, and wherein the other resin layer comprises a white-based coloring agent.
11. The back surface protective film for solar cell according to any one of 7 to 10 above, wherein the other resin layer is consisting of two or more resin layers.
12. The back surface protective film for solar cell according to any one of 1 to 11 above, having a thickness of 10 to 1,000 μm.
13. A solar cell module, characterized by comprising the back surface protective film for solar cell according to any one of 1 to 12 above.

[Effect of the Invention]

In the back surface protective film for solar cell of the present invention, since the back surface protective film has a first resin layer obtained using a first thermoplastic resin composition which is prepared by melt-kneading a starting material composition containing a first thermoplastic resin and a silane coupling agent, the back surface protective film is excellent in adhesiveness between a filling unit which embeds solar cell elements therein and contains an ethylene vinyl acetate copolymer composition and the first resin layer, and excellent in heat resistance and weathering resistance. This enables to provide a solar cell module where its filling unit is assuredly protected.
In the case where the back surface protective film for solar cell of the present invention further comprises other resin layer bonding to the first resin layer, it is possible to give a hydrolysis resistance, water resistance (moisture resistance), light reflectivity, flame resistance, or the like, depending on the nature of the resin layer.
In the case where the first thermoplastic resin contains a rubber reinforced aromatic vinyl-based resin, hydrolysis resistance, dimensional stability, impact resistance, and the like of the back surface protective film for solar cell are excellent.
In the case where the back surface protective film has a reflectance of 50% or higher to a light having a wavelength of 400 to 1,400 nm when the light is irradiated to a surface of the first resin layer of the back surface protective film for solar cell, the back surface protective film is excellent in reflectivity to a solar light at the first resin layer. Thus, even when the solar light leaks through gaps among adjacent solar cell elements toward the back surface protective film for solar cell, the light reflected thereby is supplied to the back surfaces of the solar cell elements to utilize the reflected light for photoelectric conversion, thereby enabling to improve a power generation efficiency.
Further, in the case where the first thermoplastic resin composition further contains a white-based coloring agent, the back surface protective film for solar cell is particularly excellent in reflectivity to a solar light, at the first resin layer itself. Thus, not only in the case of a single-layer type film, but also in the case of a multi-layer type film having the first resin layer and the other resin layer, as well as in the case of provision of a member at that side of the first resin layer which side is not faced with the filling unit, the back surface protective film is made to be excellent in improving effect of a power generation efficiency, irrespectively of the configuration of the other resin layer or the like.
In the case where the first resin layer has a transmittance of a light having a wavelength of 800 to 1,400 nm of 60% or higher, and an absorbance of a light having a wavelength of 400 to 700 nm of 60% or higher, a heat storage due to the light having a wavelength of 800 to 1,400 nm is restricted at the first resin layer even when the solar light leaks through gaps among adjacent solar cell elements toward the back surface protective film for solar cell, thereby also restricting a heat storage at a filling unit adhered to the first resin layer. It is then possible to restrict a heat storage at a solar cell module formed by adopting the film, thereby enabling to restrict deformation of constituent members represented by the back surface protective film, and to restrict deterioration of a power generation efficiency. It is noted that, when a member excellent in light reflectivity is provided at that side of the first resin layer which side is not faced with the filling unit, the light having transmitted through the first resin layer is reflected by a surface of this member to thereby supply the reflected light to back surfaces of the solar cell elements to utilize the reflected light for photoelectric conversion, thereby enabling to improve a power generation efficiency. Further, when the back surface protective film for solar cell of the present invention is a multi-layer type film comprising the first resin layer having such a nature, and other resin layer as the above-described member wherein the other resin layer is a white resin layer, the effect noted just above can be assuredly obtained.
Moreover, in the case where the first thermoplastic resin composition further contains an infrared transmissible coloring agent, it is enabled to provide a solar cell module in which the first resin layer exhibits a transmittance of a light having a wavelength of 800 to 1,400 nm of 60% or higher and an absorbance of a light having a wavelength of 400 to 700 nm of 60% or higher, and a dark-colored external appearance is excellent. This enables not only to restrict deformation of constituent members represented by the film and deterioration of a power generation efficiency, but also to improve an external appearance of a solar cell provided with the back surface protective film for solar cell of the present invention when the solar cell is provided on a roof or the like of a house. Further, in the case where the back surface protective film for solar cell of the present invention is a multi-layer type film comprising the first resin layer containing the infrared transmissible coloring agent and other resin layer in which the other resin layer is a white resin layer, it is enabled to restrict heat storage at the first resin layer and deformation thereof to thereby restrict a heat storage in the solar cell module, thereby exhibiting an excellently improving effect of a power generation efficiency.
The solar cell module of the present invention is excellent in shape stability due to the back surface protective film for solar cell of the present invention, and leads to a formation of a solar cell which improves a photoelectric conversion efficiency.

[Brief Description of the Drawings]

Fig. 1 is a cross-sectional view of an example of a (single-layer type) back surface protective film for solar cell of the present invention;

Fig. 2 is a cross-sectional view of an example of a (multi-layer type) back surface protective film for solar cell of the present invention;

Fig. 3 is a cross-sectional view of another example of a (multi-layer type) back surface protective film for solar cell of the present invention;

Fig. 4 is a cross-sectional view of another example of a (multi-layer type) back surface protective film for solar cell of the present invention;

Fig. 5 is a cross-sectional view of another example of a (multi-layer type) back surface protective film for solar cell of the present invention; and

Fig. 6 is a cross-sectional view of an example of a solar cell module of the present invention.

[Description of the Preferred Embodiments]

Hereinafter, the present invention will be described in greater detail. In the present specification, "(co)polymer (ize)" means homopolymer(ize) and copolymer(ize), "(meth)acryl" means acryl and methacryl, and "(meth)acrylate" means acrylate and methacrylate.

The back surface protective film for solar cell of the present invention is characterized by comprising a resin layer (hereinafter, referred to as "first resin layer") obtained using a thermoplastic resin composition (hereinafter, referred to also as "first thermoplastic resin composition") which is prepared by melt-kneading a starting material composition (hereinafter, referred to also as "first starting material composition") containing a thermoplastic resin (hereinafter, referred to also as "first thermoplastic resin") and a silane coupling agent.

The back surface protective film for solar cell of the present invention may be a single-layer type film 1A having only the first resin layer (see, Fig. 1), a multi-layer type film (including a laminate type sheet) 1B having the first resin layer 11 and other layer 15 (151-155) which is bonding to the first resin layer 11, or the like (see, Figs. 2 to 5), and the like. The other layer 15 will be described later.

In the present invention, even if the back surface protective film for solar cell of the present invention is a single-layer type film or multi-layer type film, the back surface protective film is used for adhesion between the surface of the first resin layer and an exposed surface of the filling unit of the solar cell module.

The first resin layer is a layer that is obtained using the first thermoplastic resin composition prepared by melt-kneading the first starting material composition containing the first thermoplastic resin and a silane coupling agent. Since the back surface protective film for solar cell of the present invention can be, as mentioned above, a single-layer type film consisting of only the first resin layer, the first thermoplastic resin composition is preferably a composition capable of forming a film.

The glass transition temperature (hereinafter, referred to as "Tg") of the first thermoplastic resin is in the range from 100°C to 220°C, and more preferably from 110°C to 200°C. When the glass transition temperature Tg is in the above range, flexibility and heat resistance are excellent. The glass transition temperature can be measured with a differential scanning calorimeter (DSC).

The first thermoplastic resin contained in the first starting material composition is not particularly limited so long as it is a resin having thermoplasticity and examples thereof include a rubber reinforced aromatic vinyl-based resin such as ABS resin, ASA resin and AES resin; an aromatic vinyl-based (co)polymer such as acrylonitrile styrene (co)polymer (AS resin); an acrylic resin such as a (co)polymer obtained using at least one (meth)acrylic acid ester, including poly methyl methacrylate; a vinyl chloride-based resin such as poly vinyl chloride; a vinylidene chloride-based resin such as poly vinylidene chloride; a polyamide-based resin; a polyester-based resin such as polyethylene terephthalate, polybutylene terephthalate and polyethylene naphthalate; an olefin-based resin such as polyethylene, polypropylene, ethylene vinyl acetate copolymer, ethylene vinyl chloride copolymer, ethylene vinyl alcohol copolymer and ionomer; a polycarbonate resin; a poly arylate resin; a poly vinyl acetate; and the like. These resins may be used singly or in combination of two or more types thereof.

Among these, a rubber reinforced aromatic vinyl-based resin, a polyester-based resin, and an olefin-based resin are preferable. Particularly preferred is a rubber reinforced aromatic vinyl-based resin. When the first thermoplastic resin contains a rubber reinforced aromatic vinyl-based resin, hydrolysis resistance, dimensional stability, impact resistance and the like are excellent.

The rubber reinforced aromatic vinyl-based resin is usually a copolymeric resin (A11) obtained by polymerization of a monomer (hereinafter, referred to as "vinyl-based monomer (b1)") containing an aromatic vinyl compound in the presence of a rubbery polymer (hereinafter, referred to also as "rubbery polymer (a)"), or a mixture of the copolymeric resin (A11) and an aromatic vinyl-based (co)polymer (A12) obtained by polymerization of a monomer (hereinafter, referred to as "vinyl-based monomer (b2)") containing an aromatic vinyl compound in the absence of a rubbery polymer. The content of the rubbery polymer (a) contained in the rubber reinforced aromatic vinyl-based resin is preferably in the

range from 1% to 55% by weight, and more preferably from 5% to 40% by weight. When the content of the rubbery polymer (a) is in the above range, the resultant first resin layer is excellent in adhesiveness to a filling unit including a solar cell unit, hydrolysis resistance, dimensional stability, impact resistance and the like.

The rubbery polymer (a) is not particularly limited so long as it is rubbery at room temperature. The polymer may be a homopolymer or a copolymer. In addition, this rubbery polymer (a) may be a crosslinked polymer or a non-crosslinked polymer.

In the present invention, the rubery polymer (a) is preferably a diene-based polymer and a non-diene-based polymer. These polymers may be used singly or in combination of two or more types thereof.

Examples of the diene-based polymer include a homopolymer such as polybutadiene and polyisoprene; a styrene butadiene-based copolymer; a styrene isoprene-based copolymer; a natural rubber, and the like. Each of the above-mentioned copolymers may be a block copolymer or a random copolymer. Additionally, the copolymer may be hydrogenated at a hydrogenation rate of not more than 50%. The diene-based polymer may be used singly or in combination of two or more types thereof.

Examples of the non-diene-based polymer include an ethylene $\alpha$-olefin-based copolymer rubber containing an ethylene unit, and a structural unit derived from an $\alpha$-olefin having three or more carbon atoms; a urethane-based rubber; an acrylic rubber; a silicone rubber; a silicone-acrylic complex rubber; a polymer obtained by hydrogenation of a (co) polymer containing a structural unit derived from a conjugated diene-based compound (provided that the hydrogenation ratio is typically 50% or more); and the like. Each of the copolymers may be a block copolymer or random copolymer. Preferable as the non-diene-based polymer is an acrylic rubber, from a viewpoint of weathering resistance. The non-diene-based polymer may be used singly or in combination of two or more types thereof.

The acrylic rubber is usually a (co)polymer containing a structural unit deriving from an acrylic acid alkyl ester having an alkyl group of 2-8 carbon atoms. The content of the structural unit is preferably 80% or more by weight, and more preferably 90% or more by weight, based on the total content of the structural units.

Examples of the acrylic acid alkyl ester include ethyl acrylate, propyl acrylate, n-butyl acrylate, isobutyl acrylate, hexyl acrylate, n-octyl acrylate, 2-ethylhexyl acrylate and the like. These compounds may be used singly or in combination of two or more types thereof. Among these, the acrylic acid alkyl ester is preferably n-butyl acrylate, isobutyl acrylate, and 2-ethylhexyl acrylate.

In the case where the acrylic rubber contains a structural unit deriving from other monomers, examples of the other monomers include a monofunctional monomre such as vinyl chloride, vinylidene chloride, acrylonitrile, vinyl ester, methacrylic acid alkyl ester, (meth)acrylic acid and styrene; a crosslinkable monomer such as a mono- or polyethylene glycol di(meth)acrylate including diethylene glycol di(meth)acrylate, triethylene glycol di(meth)acrylate, and tetraethylene glycol di(meth)acrylate, divinyl benzene, a di- or triallyl compound including diallyl phthalate, diallyl maleate, diallyl succinate, and triallyl triazine, an allyl compound including allyl (meth)acrylate, a conjugated diene compound including 1,3-butadiene, and the like.

Tg of the acrylic rubber is preferably -10°C or lower. Therefore, the preferable acrylic rubber in the present invention is a copolymer having a structural unit deriving from the crosslinkable monomer.

The content of the structural unit deriving from the crosslinkable monomer constituting to the preferable acrylic rubber is preferably in the range from 0.01% to 10% by weight, more preferably from 0.05% to 8%, and further preferably from 0.1% to 5% by weight, based on the total content of the structural units

The shape of the rubbery polymer (a) is not particularly limited. When the rubbery polymer (a) is in a particulate form, its volume average particle size is preferably 50 to 2,000 nm, and more preferably from 70 to 1,500 nm. Volume average particle size within the above range leads to a first thermoplastic resin composition excellent in moldability and a first resin layer excellent in impact resistance. It is noted that the volume average particle size is measurable by: an image analyzing method utilizing an electron photomicrograph; a laser diffraction method; a light scattering method; or the like.

In the case where the rubbery polymer (a) is in a particulate form, one enlarged by a known method such as methods described in JP-A S61-233010, JP-A S59-93701, JP-A S56-167704 and the like may be used so long as the volume average particle diameter is in the above range.

In consideration of controlling the average particle diameter and other factors, the method for manufacturing the rubbery polymer (a) is preferably emulsion polymerization. The average particle diameter in such case can be controlled by the selection of conditions including type and amount of an emulsifier, type and amount of a polymerization initiator, polymerization time, polymerization temperature, stirring conditions and the like. In addition, a method in which two or more types of rubbery polymer (a) having different particle diameters are blended may also be used as another method for controlling the average particle diameter (particle-diameter distribution).

The vinyl-based monomer (b1) for the formation of the copolymeric resin (A11) containing the rubber reinforced aromatic vinyl-based resin includes, as mentioned above, an aromatic vinyl compound. The vinyl-based monomer (b1) may be consisting of the aromatic vinyl compound or in combination of the aromatic vinyl compound and other monomers. Examples of the other monomers include a cyanidated vinyl compound, a (meth)acrylic acid ester compound, a maleimide-based compound, an unsaturated acid anhydride, an unsaturated compound having a carboxyl group, an unsaturated compound having a hydroxyl group, an unsaturated compound having an amino group, an unsaturated compound having an amide group, an unsaturated compound having an epoxy group, an unsaturated compound having an oxazoline group, and the like. These monomers may be used singly or in combination of two or more thereof.

The aromatic vinyl compound is not particularly limited so long as it is a compound having at least one vinyl bond and at least one aromatic ring. An example thereof includes styrene, α-methyl styrene, o-methyl styrene, p-methyl styrene, β-methyl styrene, ethyl styrene, p-tert-butyl styrene, vinyl toluene, vinyl xylene, vinyl naphthalene, monochlorostyrene, dichlorostyrene, monobromostyrene, dibromostyrene, tribromostyrene, fluorostyrene and the like. These compounds may be used singly or in combination of two or more types thereof. In addition, styrene and α-methyl styrene are preferable among these. Particularly preferred is styrene.

Examples of the cyanidated vinyl compound include acrylonitrile, methacrylonitrile, ethacrylonitrile, α-ethyl acrylonitrile, α-isopropyl acrylonitrile, α-chloro acrylonitrile, α-fluoro acrylonitrile and the like. Among these, acrylonitrile is preferred. In addition, these compounds may be used singly or in combination of two or more types thereof.

Examples of the (meth)acrylic acid ester compound include methyl (meth)acrylate, ethyl (meth)acrylate, n-propyl (meth)acrylate, isopropyl (meth)acrylate, n-butyl (meth)acrylate, isobutyl (meth)acrylate, sec-butyl (meth)acrylate, tert-butyl (meth)acrylate, hexyl (meth)acrylate, n-octyl (meth)acrylate, 2-ethylhexyl (meth)acrylate, cyclohexyl (meth) acrylate, phenyl (meth)acrylate, benzyl (meth)acrylate and the like. These compounds may be used singly or in combination of two or more types thereof.

Examples of the maleimide-based compound include maleimide, N-methyl maleimide, N-isopropyl maleimide, N-butyl maleimide, N-dodecyl maleimide, N-phenyl maleimide, N-(2-methylphenyl)maleimide, N-(4-methylphenyl) maleimide, N-(2,6-dimethylphenyl) maleimide, N-(2,6-diethylphenyl) maleimide, N-(2-methoxyphenyl) maleimide, N-benzyl maleimide, N-(4-hydroxyphenyl)maleimide, N-naphthyl maleimide, N-cyclohexyl maleimide and the like. These compounds may be used singly or in combination of two or more types thereof. Another method for introducing a monomer unit deriving from the maleimide-based compound into the rubber reinforced aromatic vinyl-based resin includes an imidization after copolymerization with maleic anhydride.

Examples of the unsaturated acid anhydride include maleic anhydride, itaconic anhydride, citraconic anhydride and the like. These compounds may be used singly or in combination of two or more types thereof.

Examples of the unsaturated compound having a carboxyl group include (meth)acrylic acid, ethacrylic acid, maleic acid, fumaric acid, itaconic acid, crotonic acid, cinnamic acid, and the like. These compounds may be used singly or in combination of two or more types thereof.

Examples of the unsaturated compound having a hydroxyl group include a (meth)acrylic acid ester having a hydroxyl group such as 2-hydroxymethyl (meth)acrylate, 2-hydroxyethyl (meth)acrylate, 3-hydroxypropyl (meth)acrylate, 2-hydroxybutyl (meth)acrylate, 3-hydroxybutyl (meth)acrylate, 4-hydroxybutyl (meth)acrylate, polyethylene glycol mono (meth)acrylate, polypropylene glycol mono(meth)acrylate, and a compound obtained by addition of ε-caprolacton to 2-hydroxymethyl (meth)acrylate; o-hydroxy styrene, m-hydroxy styrene, p-hydroxy styrene, o-hydroxy-α-methylstyrene, m-hydroxy-α-methylstyrene, p-hydroxy-α-methylstyrene, 2-hydroxymethyl-α-methylstyrene, 3-hydroxymethyl-α-methylstyrene, 4-hydroxymethyl-α-methylstyrene, 4-hydroxymethyl-1-vinyl naphthalene, 7-hydroxymethyl-1-vinyl naphthalene, 8-hydroxymethyl-1-vinyl naphthalene, 4-hydroxymethyl-1-isopropenyl naphthalene, 7-hydroxymethyl-1-isopropenyl naphthalene, 8-hydroxymethyl-1-isopropenyl naphthalene, p-vinylbenzyl alcohol, and the like. These compounds may be used singly or in combination of two or more types thereof.

Examples of the unsaturated compound having an amino group include aminoethyl (meth) acrylate, propylaminoethyl (meth) acrylate, dimethylaminomethyl (meth)acrylate, diethylaminom aminoethyl (meth)acrylate, 2-dimethylaminoethyl (meth)acrylate, 2-diethylaminoethyl (meth)acrylate, 2-(di-n-propylamino)ethyl (meth)acrylate, 2-dimethylaminopropyl (meth)acrylate, 2-diethylaminopropyl (meth)acrylate, 2-(di-n-propylamino)propyl (meth)acrylate, 3-dimethylaminopropyl (meth)acrylate, 3-diethylaminopropyl (meth)acrylate, 3-(di-n-propylamino)propyl (meth)acrylate, 2-tert-butylaminoethyl (meth)acrylate, phenylaminoethyl (meth)acrylate, 4-aminostyrene, 4-dimethylaminostyrene, N-vinyl diethyl amine, N-acetyl vinyl amine, (meth)acrylamine, N-methyl (meth)acrylamine, and the like. These compounds may be used singly or in combination of two or more types thereof.

Examples of the unsaturated compound having an amide group include (meth)acrylamide, N-methylol (meth) acrylamide, 3-dimethylaminopropyl (meth)acrylamide, and the like. These compounds may be used singly or in combination of two or more types thereof.

Examples of the unsaturated compound having an epoxy group include glycidyl (meth)acrylate, 3,4-oxycyclohexyl (meth)acrylate, vinyl glycidyl ether, allyl glycidyl ether, methallyl glycidyl ether, and the like. These compounds may be used singly or in combination of two or more types thereof.

The preferable other monomers are a cyanidated vinyl compound and a maleimide-based compound. It is particularly preferable that the other monomer contains a cyanidated vinyl compound. The cyanidated vinyl compound is preferably an acrylonitrile. Moreover, the maleimide-based compound is preferably an N-phenyl maleimide.

When the vinyl-based monomer (b1) contains an aromatic vinyl compound and cyanidated vinyl compound, the total

amount of these compounds are preferably in the range from 70% to 100% by weight, and more preferably from 80% to 100% by weight based on 100% by weight of the total of the vinyl-based monomer (b1). Additionally, the ratio of the aromatic vinyl compound and cyanidated vinyl compound to be used are preferably in the range from 5% to 95% and in the range from 5% to 95%, more preferably from 20% to 90% and from 10% to 80%, and further preferably from 30% to 85% and from 15% to 70%, respectively, based on 100% by weight of the total of these monomers, from viewpoints of hydrolysis resistance, moldability and toughness.
When the vinyl-based monomer (b1) is consisting of an aromatic vinyl compound, cyanidated vinyl compound and maleimide-based compound, contents ratio thereof are preferably 20% to 90% by weight, 5% to 45% by weight, and 1% to 50% by weight, more preferably 30% to 85% by weight, 10% to 40% by weight, and 2% to 40% by weight, and further preferably 40% to 80% by weight, 15% to 35% by weight, and 3% to 30% by weight, respectively, based on 100% by weight of the total amounts of these, from view points of hydrolysis resistance, chemical resistance, heat resistance, and the like.

The preferable copolymeric resin (A11) constituting to the rubber reinforced aromatic vinyl-based resin is as follows:

(1) a copolymeric resin obtained by polymerizing the vinyl-based monomer (b1) consisting of an aromatic vinyl compound and a cyanidated vinyl compound in the presence of the rubbery polymer (a),
(2) a copolymeric resin obtained by polymerizing the vinyl-based monomer (b1) consisting of an aromatic vinyl compound, a cyanidated vinyl compound and a maleimide-based compound in the presence of the rubbery polymer (a), and
(3) a copolymeric resin obtained by polymerizing the vinyl-based monomer (b1) consisting of an aromatic vinyl compound, a cyanidated vinyl compound and a (meth)acrylic acid ester compound in the presence of the rubbery polymer (a).

The copolymeric resin (A11) can be produced by polymerizing the vinyl-based monomer (b1) in the presence of the rubbery polymer (a). The preferable polymerization method is an emulsification polymerization, solution polymerization, bulk polymerization and bulk-suspension polymerization.

When the copolymeric resin (A11) is produced, the reaction may be conducted by charging all of the vinyl-based monomer (b1) at once in the presence of the whole amount of the rubbery polymer (a), or by charging the vinyl-based monomer (b1) dividedly or continuously. In addition, all of the vinyl-based monomer (b1) may be added in the presence of a part of the rubbery polymer (a) or in the absence of the rubbery polymer (a) for polymerization. The polymerization of the vinyl-based monomer (b1) may be initiated while charging dividedly or continuously. In this case, the rest of the rubbery polymer (a) may be charged all at once, dividedly or continuously.

When 100 parts by weight of the copolymeric resin (A11) is produced, the rubbery polymer (a) is usually used in an amount from 10 to 70 parts by weight. The vinyl-based monomer (b1) is usually used in an amount from 43 to 900 parts by weight based on 100 parts by weight of the rubbery polymer (a).

In the case of producing the copolymeric resin (A11) by emulsion polymerization, a polymerization initiator, a chain-transfer agent (molecular weight adjuster), an emulsifier, water and the like are used.

Examples of the polymerization initiator include a redox-type initiator by combining an organic peroxide such as cumene hydroperoxide, diisopropylbenzene hydroperoxide and p menthane hydroperoxide, and a reducing agent such as sugar-containing pyrophosphoric acid formulation and sulfoxylate formulation; a persulfate such as potassium persulfate; a peroxide such as benzoyl peroxide (BPO), lauroyl peroxide, tert-butylperoxy laurate and tert-butylperoxy monocarbonate; and the like. These compounds may be used singly or in combination of two or more types thereof. The polymerization initiator is usually used in an amount from 0.1% to 1.5% by weight based on the total amount of the vinyl-based monomer (b1).
The polymerization initiator can be incorporated into the reaction system all at once or continuously.

Examples of the chain-transfer agent include a mercaptan such as octyl mercaptan, n-dodecyl mercaptan, tert-dodecyl mercaptan, n-hexyl mercaptan, n-hexadecyl mercaptan, n-tetradecyl mercaptan and tert-tetradecyl mercaptan; a terpinolene, $\alpha$-methyl styrene dimer, and the like. These may be used singly or in combination of two or more types thereof. The chain-transfer agent is usually used in an amount from 0.05% to 2.0% by weight based on the total amount of the vinyl-based monomer (b1).
The chain-transfer agent can be incorporated into the reaction system all at once or continuously.

Examples of the emulsifier include an anionic surfactant and a nonionic surfactant. Examples of the anionic surfactant include a sulfuric acid ester of a higher alcohol, an alkyl benzene sulfonate including sodium dodecylbenzene sulfonate, an aliphatic sulfonate including sodium lauryl sulfonate, a higher aliphatic carboxylate, a phosphate-based compound, and the like. Examples of the nonionic surfactant include an alkyl ester type compound or alkyl ether type compound of a polyethylene glycol; and the like. These may be used singly or in combination of two or more types thereof. The emulsifier is used usually in an amount from 0.3% to 5.0% by weight based on the total amount of the vinyl-based monomer (b1).

The emulsion polymerization can be conducted in publicly known conditions according to the types of the vinyl-based monomer (b1), polymerization initiator and the like. A latex obtained by emulsion polymerization is usually subjected to solidification by a coagulant, the polymer component is pulverized, and then the product is purified by rinsing and drying. The coagulant may be used an inorganic salt such as calcium chloride, magnesium sulfate, magnesium chloride and sodium chloride; an inorganic acid such as sulfuric acid and hydrochloric acid; an organic acid such as acetic acid and lactic acid; and the like.

In the case of making two or more copolymeric resins (A11) contain in the rubber reinforced aromatic vinyl-based resin, blending may be conducted after isolation of a resin from a latex. Other method is one where a mixture of latexes containing resins respectively is subjected to coagulation.

The production method for the copolymeric resin (A11) by solution polymerization, bulk polymerization, and bulk-suspension polymerization may be applied to publicly known method.

A rubber reinforced aromatic vinyl-based resin containing the copolymeric resin (A11) obtained in the case of using a diene-based polymer as the rubbery polymer (a1) is usually called "ABS resin". A rubber reinforced aromatic vinyl-based resin containing the copolymeric resin (A11) obtained in the case of using an ethylene $\alpha$-olefin-based copolymer rubber as the rubbery polymer (a1) is usually called "AES resin". In addition, a rubber reinforced aromatic vinyl-based resin containing the copolymeric resin (A11) obtained in the case of using an acrylic rubber as the rubbery polymer (a1) is usually called "ASA resin".

The graft ratio of the copolymeric resin (A11) is preferably in the range from 20% to 170% by weight, more preferably from 30% to 170% by weight, and particularly from 40% to 150% by weight. If the graft ratio is too low, flexibility of the first resin layer obtained using the first thermoplastic resin composition may not be sufficient. On the other hand, if the graft ratio is too high, viscosity of the first thermoplastic resin composition may be increased, and a production of a thin-walled article may be difficult.

The graft ratio is obtainable by the following equation:

$$\text{Graft ratio (\% by weight)} = \{(S-T)/T\} \times 100$$

In the equation, S is a weight (gram) of an insoluble component obtained by: adding 1 gram of a rubber reinforced aromatic vinyl-based resin into 20 milliliters of acetone (or acetonitrile, in case that the rubbery polymer is an acrylic rubber); shaking the mixture at a temperature of 25°C for 2 hours by a shaker; and then subjecting the mixture to centrifugal separation at a temperature of 5°C for 60 minutes with a centrifuge (rotational speed: 23,000 rpm), to separate the insoluble component from a soluble component; and T is a weight (gram) of a rubbery polymer contained in 1 gram of rubber reinforced aromatic vinyl-based resin. The weight of the rubbery polymer is obtainable by: a method for calculating it from a polymerization formulation and a polymerization conversion ratio; a method for obtaining it by an infrared absorption spectrum (IR); or the like.

The copolymeric resin (A11) may be used singly or in combination of two or more types thereof.

The rubber reinforced aromatic vinyl-based resin is preferably ABS resin, ASA resin and AES resin, more preferably ABS resin and ASA resin, and particularly ASA resin.

When the rubber reinforced aromatic vinyl-based resin is a mixture of the copolymeric resin (A11) and an aromatic vinyl-based (co)polymer (A12), the aromatic vinyl-based (co)polymer (A12) is not particularly limited so long as it is a (co)polymer obtained by polymerizing a vinyl-based monomer (b2) containing an aromatic vinyl compound in the absence of a rubbery polymer. That is, the aromatic vinyl-based (co)polymer (A12) may be a homopolymer or copolymer, and be in combination of these polymers.

The vinyl-based monomer (b2) may be only an aromatic vinyl compound, or in combination of the aromatic vinyl compound and other monomer. Examples of the other monomer include a cyanidated vinyl compound, a (meth) acrylic acid ester compound, a maleimide-based compound, an unsaturated acid anhydride, an unsaturated compound having a carboxyl group, an unsaturated compound having a hydroxyl group, an unsaturated compound having an amino group, an unsaturated compound having an amide group, an unsaturated compound having an epoxy group, an unsaturated compound having an oxazoline group, and the like. These monomers may be used singly or in combination of two or more thereof.

The aromatic vinyl-based (co)polymer (A12) is preferably a copolymer. In the present invention, the vinyl-based monomer (b2) is preferably of an aromatic vinyl compound and other monomers. The other monomers are preferably a cyanidated vinyl compound and a maleimide-based compound.

When the vinyl-based monomer (b2) contains an aromatic vinyl compound and cyanidated vinyl compound, the total content of these compounds is preferably in the range from 70% to 100% by weight, and more preferably from 80% to 100% by weight based on the total amount of the vinyl-based monomer (b1). Amounts ratio of the aromatic vinyl compound

and cyanidated vinyl compound to be used are preferably from 5% to 95% by weight and from 5% to 95% by weight, more preferably from 50% to 95% by weight and from 5% to 50% by weight, further preferably from 60% to 95% by weight and from 5% to 40% by weight, and particularly from 65% to 85% by weight and from 15% to 35% by weight, respectively, based on 100% by weight of the total of these, from viewpoints of hydrolysis resistance, chemical resistance, and the like.

When the aromatic vinyl-based (co)polymer (A12) is a copolymer, preferable polymers are as follows:

(1) a copolymer consisting of a structural unit deriving from an aromatic vinyl compound (hereinafter, referred to as "structural unit (s)") and a structural unit deriving from a cyanidated vinyl compound (hereinafter, referred to as "structural unit (t)"), and
(2) a copolymer consisting of a structural unit (s) deriving from an aromatic vinyl compound, a structural unit (t) deriving from a cyanidated vinyl compound, and a structural unit deriving from a maleimide-based compound (hereinafter, referred to as "structural unit (u)").

When the aromatic vinyl-based (co)polymer (A12) is in the embodiment (1) above, contents ratio of the structural unit (s) and structural unit (t) are preferably from 5% to 95% by weight and from 5% to 95% by weight, more preferably from 50% to 95% by weight and from 5% to 50% by weight, further preferably from 60% to 95% by weight and from 5% to 40% by weight, and particularly from 65% to 85% by weight and from 15% to 35% by weight, respectively, based on 100% by weight of the total of these units, from viewpoints of hydrolysis resistance, chemical resistance, and the like.
Examples of the copolymer of the embodiment (1) above include acrylonitrile styrene copolymer, acrylonitrile α-methyl styrene copolymer, and the like.

When the aromatic vinyl-based (co)polymer (A12) is in the embodiment (2) above, contents ratio of the structural unit (s), structural unit (t) and structural unit (u) are preferably from 20% to 85% by weight, from 2% to 50% by weight and from 3% to 60% by weight, more preferably from 25% to 80% by weight, from 4% to 40% by weight and from 5% to 55% by weight, further preferably from 30% to 75% by weight, from 5% to 35% by weight and from 10% to 50% by weight, respectively, based on 100% by weight of the total of these units, from viewpoints of hydrolysis resistance, chemical resistance and heat resistance.
Examples of the copolymer of the embodiment (2) above include acrylonitrile styrene N-phenyl maleimide copolymer, and the like.
Other example is an acrylonitrile styrene methyl methacrylate copolymer or the like.

The aromatic vinyl-based (co)polymer (A12) can be produced by polymerizing the vinyl-based monomer (b2) containing an aromatic vinyl compound, in the presence or absence of a polymerization initiator. When the polymerization initiator is used, the polymerization method is preferably a solvent polymerization, bulk polymerization, emulsion polymerization, suspension polymerization and the like. These polymerizations may be combined. When the polymerization initiator is not used, thermal polymerization is usable.

The polymerization initiator to be used is one which is exemplified in the description of the production for the copolymeric resin (A11), and the compound may be used singly or in combination of two or more types thereof.
The amount of the polymerization initiator to be used is usually in the range from 0.1% to 1.5% by weight based on the total amount of the vinyl-based monomer (b2).
It is noted that a chain-transfer agent, emulsifier and the like that are exemplified in the description of the production for the copolymeric resin (A11) may be used if necessary.

When the aromatic vinyl-based (co)polymer (A12) is produced, the polymerization may be initiated in a state that the total amount of the vinyl-based monomer (b2) is contained in a reaction system, or the polymerization may be conducted while charging an arbitrarily selected monomer component dividedly or continuously. Further, in the case of using a polymerization initiator, batch-wise or continuous addition into the reaction system is possible.

The aromatic vinyl-based (co)polymer (A12) may be used singly or in combination of two or more types thereof.

When the rubber reinforced aromatic vinyl-based resin is consisting of the copolymeric resin (A11), and when the rubber reinforced aromatic vinyl-based resin is consisting of a mixture of the copolymeric resin (A11) and the aromatic vinyl-based (co)polymer (A12), the intrinsic viscosity [η] (measured in methyl ethyl ketone at a temperature of 30°C) of a component dissolved by acetone (acetonitrile is used in the case where an acrylic rubber is used as the rubbery polymer) in the rubber reinforced aromatic vinyl-based resin is preferably in the range from 0.1 to 2.5 dl/g, more preferably from 0.2 to 1.5 dl/g, and further preferably from 0.2 to 1.2 dl/g. The intrinsic viscosity [η] having the above range leads to an excellent moldability of the first thermoplastic resin composition and an excellent thickness accuracy of the first resin layer.

Here, the intrinsic viscosity [η] can be obtained by the following procedure.
Namely, the acetone-soluble component (or acetonitrile-soluble component, in case that the rubbery polymer is an acrylic rubber) collected after centrifugal separation upon obtaining the graft ratio in case of the rubber reinforced aromatic vinyl-based resin (copolymeric resin (A11)), is dissolved in methyl ethyl ketone to prepare five specimens having different

concentrations; and reduced viscosities of the respective concentrations are measured at a temperature of 30°C with Ubbelohde viscometer tube, thereby obtaining the intrinsic viscosity [η].

The graft ratio and intrinsic viscosity [η] can easily be controlled by varying types or amounts of the polymerization initiator, the chain-transfer agent, the emulsifier, the solvent and the like, and by varying polymerization time, polymerization temperature and other conditions in producing the copolymeric resin (A11) and the aromatic vinyl-based (co) polymer (A12).

In the case of imparting heat resistance to the first resin layer, the rubber reinforced aromatic vinyl-based resin preferably contains a structural unit (u) deriving from a maleimide-based compound. The structural unit (u) may be derived from the copolymeric resin (A11) or aromatic vinyl-based (co)polymer (A12). The unit may be derived from both polymers.
The content of the structural unit (u) for the formation of the first resin layer excellent in heat resistance is preferably in the range from 1% to 30% by weight, and more preferably from 5% to 28% by weight based on 100% by weight of the rubber reinforced aromatic vinyl-based resin. If the content of the structural unit (u) is too high, flexibility of the first resin layer may be lowered.

The polyester-based resin is not particularly limited so long as it has an ester bond in the principal chain of the molecule. In usual, a saturated polyester resin is used. The saturated polyester resin may be a homopolymerized polyester or a copolymerized polyester.

The polyester-based resin to be used may be, for example, a resin obtained by polycondensation of a dicarboxylic acid component and a dihydroxy component, polycondensation of an oxycarboxylic acid or a lactone component, or the like.
Examples of the dicarboxylic acid component include an aromatic dicarboxylic acid having about 8-16 carbon atoms or a derivative compound thereof such as terephthalic acid, isophthalic acid, phthalic acid, naphthalene dicarboxylic acid including 2,6-naphthalene dicarboxylic acid, diphenyl dicarboxylic acid,
diphenylether dicarboxylic acid, diphenylmethane dicarboxylic acid, diphenylethane dicarboxylic acid, and diphenylketone dicarboxylic acid; an alicyclic dicarboxylic acid having about 8-12 carbon atoms or a derivative compound thereof such as cyclohexane dicarboxylic acid, hexahydro phthalic acid, hexahydro isophthalic acid, hyxahydro terephthalic acid and himic acid; an aliphatic dicarboxylic acid having about 2-40 carbon atoms or a derivative compound thereof such as adipic acid, pimeric acid, suberic acid, azelaic acid, sebacic acid, dodecane dicarboxylic acid, hexadecane dicarboxylic acid and dimer acid; and the like.

The derivative compounds include a compound capable of forming an ester, such as a lower alkylester including dimethylester; an acid anhydride; an acid halide including an acid halide; and the like.
The dicarboxylic acid component may be used singly or in combination of two or more types thereof.

Examples of the dihydroxy component include a linear or branched aliphatic alkylene diol having about 2-12 carbon atoms such as ethylene glycol, trimethylene glycol, propylene glycol, 1,3-butane diol, 1,4-butane diol, neopentyl glycol, hexane diol, octane diol, and decane diol; an alicyclic diol such as cyclohexane diol, cyclohexane dimethanol and hydrogenated bisphenol A; an aromatic diol such as hydroquinone, resolcin, dihydroxyphenyl, naphthalene diol, dihydroxy diphenylether, bisphenol A, a compound in which an alkyleneoxide such as ethylene oxide and propylene oxide is added to bisphenol A, including diethoxylated bisphenol A; a polyoxyalkylene glycol such as diethylene glycol, triethylene glycol, polyoxymethylene glycol, ditetramethylene glycol, polytetramethylene glycol, dipropylene glycol, tripropylene glycol, polyoxypropylene glycol and polytetramethyleneether glycol; and the like.

The dihydroxy component may be a substituted compound by, for example, an alkyl group, alkoxy group, halogen atom or the like.
The dihydroxy component may be used singly or in combination of two or more types thereof.

Examples of the oxycarboxylic acid component include an oxycarboxylic acid such as oxybenzoic acid, oxynaphthoic acid and diphenylene oxycarboxylic acid; a derivative compound thereof; and the like.
The oxycarboxylic acid component may be used singly or in combination of two or more types thereof.

Examples of the lactone acid component include propiolactone, butylolactone, valerolactone, ε-caprolactone and the like.
The lactone acid component may be used singly or in combination of two or more types thereof.

When the polyester-based resin is a copolymerized polyester, examples of the monomer capable of copolymerizing therefor include an alkylene glycol such as a linear alkylene glycol including ethylene glycol, propylene glycol, and 1,4-butane diol; a polyoxyalkylene glycol having a poly(oxy-alkylene) unit and an oxyalkylene unit in which repeating number is about 2-4, such as diethylene glycol; an aliphatic dicarboxylic acid such as adipic acid, pimeric acid, suberic acid, azelaic acid and sebacic acid; an aromatic dicarboxylic acid such as phthalic acid and isophthalic acid; and the like.
In addition to the above compounds, a multifunctional monomer can be used in combination including a multiple carboxylic acid such as trimellitic acid, trimesic acid and piromellitic acid; a multiple alcohol such as glycerol, trimethylolpropane and pentaerythritol.

Examples of the polyester resin include a homopolymerized polyester such as a polyalkylene terephthalate

including polyethylene terephthalate (PET), polypropylene terephthalate (PPT), polybutylene terephthalate (PPT), polyhexamethylene terephthalate, polycyclohexane-1,4-dimethylterephthalate, polyneopentyl terephthalate, and the like; polyethylene isophthalate; a polyalkylene naphthalate including polyethylene naphthalate, polybutylene naphthalate, polyhexamethylene naphthalate, and the like; a copolymerized polyester having mainly an alkylene terephthalate unit and/or an alkylene naphthalate unit; and liquid crystal polyester. Among these, polybutylene terephthalate is preferred. Additionally, the polyester resin may be used singly or in combination of two or more types thereof.

The olefin-based resin is not particularly limited so long as it contains a structural unit deriving from an α-olefin having 2 or more carbon atoms. Preferable olefin-based resin is a polymer containing a structural unit deriving from an α-olefin having 2-10 carbon atoms. Therefore, examples of the olefin-based resin include a (co)polymer containing at least one structural unit deriving from an α-olefin having 2-10 carbon atoms mainly; a copolymer containing at least one structural unit deriving from an α-olefin having 2-10 carbon atoms and at least one structural unit deriving from a compound capable of polymerizing with the α-olefin mainly; and the like. These polymers may be used singly or in combination of two or more types thereof.

Examples of the α-olefin include ethylene, propylene, butene-1, pentene-1, hexene-1, 3-methylbutene-1, 4-methylpentene-1, 3-methylhexene-1, vinyl acetate, vinyl chloride, vinyl alcohol, and the like. These compounds may be used singly or in combination of two or more types thereof. Among these, ethylene, propylene, butene-1, 3-methylbutene-1 and 4-methylpentene-1 are preferable.

Examples of a compound for the formation of the other structural unit constituting to the olefin-based resin include a non-conjugated diene such as 4-methyl-1,4-hexadiene, 5-methyl-1,4-hexadiene, 7-methyl-1,6-octadiene and 1,9-decadiene, and the like. These compounds may be used singly or in combination of two or more types thereof.

Examples of the olefin-based resin include polyethylene, polypropylene, ethylene propylene copolymer, polybutene-1, ethylene butene-1 copolymer, ethylene vinyl acetate copolymer, ethylene vinyl chloride copolymer, ethylene vinyl alcohol copolymer, ionomer, and the like.

The olefin-based resin may be crystalline or amorphous.

The melting point (according to JIS K7121) of the olefin-based resin is preferably 40°C or higher.

Further, the molecular weight of the olefin-based resin is not particularly limited. The melt flow rate (according to JIS K7210, and hereinafter, referred to also as "MFR"), from a viewpoint of moldability, is preferably in the range from 0.01 to 500 g/10 min., and more preferably from 0.05 to 100 g/10 min. where the molecular weight corresponds to the applicable value of the melt flow rate.

Next, a silane coupling agent contained in the first starting material composition is not particularly limited. The silane coupling agent may be water-soluble or water-insoluble. In the present invention, the following organic silane compound is preferable which is represented by the general formula (1).

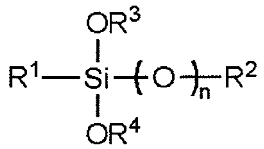

(1)

In the formula, $R^1$ is an organic group containing at least one of vinyl group, amino group, acryloyl group, methacryloyl group and epoxy bond, $R^2$, $R^3$ and $R^4$ may be same or different from each other and are hydrocarbon groups in which at least one halogen atom may be substituted, and n is 0 or 1.]

The amino group as $R^1$ in the general formula (1) may be a primary amino group, secondary amino group, ternary amino group, or alkylene polyamino group.

Examples of the organic group containing an epoxy bond include γ-glycidoxypropyl group, and the like.

The hydrocarbon group capable of substituting with a halogen atom as $R^2$, $R^3$ and $R^4$ in the general formula (1) is preferably an organic group having 1-10 carbon atoms, and may be a linear or branched aliphatic hydrocarbon group or an aromatic hydrocarbon group.

Examples of the organic silane compound represented by the general formula (1) include a vinylsilane coupling agent such as vinyl trimethoxysilane, vinyl triethoxysilane, vinyl triisopropoxysilane, vinyl tris(β-methoxyethoxy)silane, and allyl trimethoxysilane; an aminosilane coupling agent such as 3-aminopropyl trimethoxysilane, 3-aminopropyl triethoxysilane, 3-(2-aminoethyl)aminopropyl trimethoxysilane, and 3-(2-aminoethyl)aminopropylmethyl dimethoxysilane; an acrylsilane coupling agent such as 3-acryloyloxypropyl trimethoxysilane, 3-acryloyloxypropyl triethoxysilane, 3-acryloyloxypropylmethyl dimethoxysilane, and 3-acryloyloxypropylmethyl diethoxysilane; a methacrylsilane coupling agent such as 3-methacryloyloxypropyl trimethoxysilane, 3-methacryloyloxypropyl triethoxysilane, 3-methacryloyloxypropylmethyl dimethoxysilane, and 3-methacryloyloxypropylmethyl diethoxysilane; an epoxysilane coupling agent such as γ-glycidoxypropyl trimethoxysilane, γ-glycidoxypropyl triethoxysilane, β-(3,4-epoxycyclohexyl)ethyl trimethoxysilane, γ-glycidoxypropylmethyl dimethoxysilane, and γ-glycidoxypropylmethyl diethoxysilane; and the like. These compounds may be used singly or in combination of two or more types thereof. Among the above compounds, an acrylsilane coupling agent and a methacrylsilane coupling agent are preferable.

The content of the silane coupling agent contained in the first starting material composition is preferably in the range from 0.05 to 20 parts by weight, more preferably from 0.07 to 15 parts by weight, and further preferably from 0.1 to 10 parts by weight based on 100 parts by weight of the first thermoplastic resin. When the content of the silane coupling agent is in the above range, the obtained first resin layer is excellent in adhesiveness to a filling unit containing an ethylene vinyl acetate copoylmer composition or the like, and including a solar cell element. If the content of the silane coupling agent is too much, appearance of the back surface protective film for solar cell of the present invention, having the first resin layer tends to be deteriorated. On the other hand, if the content is too little, adhesiveness to the filling unit tends to be deteriorated.

The first starting material composition may be one containing an additive depending on purpose or application. Examples of this additive include an antioxidant, an ultraviolet absorber, an anti-aging agent, a coloring agent, a fluorescent brightening agent, a weather resisting agent, a filler, an anti-static agent, a flame retardant, an anti-fogging agent, an anti-bacterial agent, a fungicide, an anti-fouling agent, a tackifier, and the like.

Examples of the antioxidant include a hindered amine-based compound, a hydroquinone-based compound, a hindered phenol-based compound, a sulfur-containing compound, a phosphorus-containing compound, and the like. These compounds may be used singly or in combination of two or more types thereof.

The content of the antioxidant is preferably in the range from 0.05 to 10 parts by weight with respect to 100 parts by weight of the first thermoplastic resin.

Examples of the ultraviolet absorber include a benzophenone-based compound, a benzotriazole-based compound, a triazine-based compound, and the like. These compounds may be used singly or in combination of two or more types thereof.

The content of the ultraviolet absorber is preferably in the range from 0.05 to 10 parts by weight with respect to 100 parts by weight of the first thermoplastic resin.

Examples of the anti-aging agent include a naphthylamine-based compound, a diphenylamine-based compound, p-phenylenediamine-based compound, a quinoline-based compound, a hydroquinone-based compound, a monophenol-based compound, a bisphenol-based compound, a trisphenol-based compound, a polyphenol-based compound, a thiobisphenol-based compound, a hindered phenol-based compound, a phosphate ester-based compound, an imidazol-based compound, a dithiocarbamic acid nickel salt-based compound, a phosphate-based compound and the like. These compounds may be used alone or in combination of two or more types thereof. The content of the anti-aging agent is preferably in the range 0.05 to 10 parts by weight with respect to 100 parts by weight of the first thermoplastic resin.

Examples of the plasticizer include a phthalic acid ester such as dimethyl phthalate, diethyl phthalate, dibutyl phthalate, diisobutyl phthalate, dioctyl phthalate, butyloctyl phthalate, di-(2-ethylhexyl) phthalate, diisooctyl phthalate and diisodecyl phthalate; a fatty acid ester such as dimethyl adipate, diisobutyl adipate, di-(2-ethylhexyl) adipate, diisooctyl adipate, diisodecl adipate, octyldecyl adipate, di-(2-ethylhexyl) azelate, diisooctyl azelate, diisobutyl azelate, dibutyl sebacate, di-(2-ethylhexyl) sebacate and diisooctyl sebacate; a trimellitic acid ester such as trimellitic acid isodecyl ester, trimellitic acid octyl ester, trimellitic acid n-octyl ester and trimellitic acid isononyl-based ester; di-(2-ethylhexyl) fumalate, diethylene glycol monooleate, glyceryl monoricinolate, trilauryl phosphate, tristearyl phosphate, tri-(2-ethylhexyl) phosphate, an epoxidized soybean oil, a polyetherester and the like. These compounds may be used alone or in combination of two or more types thereof.

The content of the plasticizer is preferably in the range 0.05 to 10 parts by weight of the first thermoplastic resin.

The first resin layer is a layer which is formed using a first thermoplastic resin composition obtained by melt-kneading the first starting material composition containing the first thermoplastic resin and a silane coupling agent.

The method for melt-kneading the first starting material composition is not particularly limited. Example thereof includes: a method in which all components containing the first thermoplastic resin and a silane coupling agent is melt-kneaded; a method in which other starting material components are added dividedly or continuously while melt-kneading the first thermoplastic resin and the silane coupling agent, and melt-kneading is continued; a method in which the silane coupling agent is added dividedly or continuously while melt-kneading the first thermoplastic resin and other starting material components, and melt-kneading is continued; a method in which the silane coupling agent and other starting material components are added while melt-kneading the first thermoplastic resin, and melt-kneading is continued; and the like.

Examples of an apparatus for melt-kneading include a single screw extruder, twin-screw extruder, Banbury mixer, kneader, continuous kneader, and the like.

When the back surface protective film for solar cell of the present invention is a single-layer type film 1A shown in Fig. 1, the production method thereof is not particularly limited. Examples thereof include an extrusion method such as inflation film molding method and T-die cast film molding method, a calendar molding method, a press molding method,

and the like.

Since the back surface protective film for solar cell of the present invention has a first resin layer obtained using the first thermoplastic resin composition, the back surface protective film is excellent in adhesiveness between the first resin layer and a filling unit which embeds solar cell elements therein and contains an ethylene vinyl acetate copolymer composition and the like, without providing any adhesive layer on a surface of the first resin layer side to adhere the first resin and the filling unit which embeds solar cell elements. In addition, since the first resin layer has the above configration, when the back surface protective film for solar cell of the present invention is a multi-layer type film having the first resin layer 11 and the other layer 15, the back surface protective film is also excellent in adhesiveness between the first resin layer 11 and the other layer 15, particularly other resin layer or the like, facing with this first resin layer.

The thickness of the back surface protective film for solar cell of the present invention is preferably in the range from 10 to 1,000 μm. The lower limit of the thickness is preferably 15 μm, more preferably 20 μm, and further preferably 25 μm. On the other hand, the upper limit of the thickness is preferably 950 μm, more preferably 900 μm, and further preferably 850 μm.

When the back surface protective film for solar cell of the present invention is a single-layer type film (of only the first resin layer), the lower limit of the thickness is preferably 10 μm, more preferably 15 μm, and further preferably 20 μm, from a viewpoint of adhesiveness to the filling unit. On the other hand, the upper limit of the thickness is usually 1,000 μm, preferably 800 μm, more preferably 600 μm, and further preferably 500 μm.

The back surface protective film for solar cell of the present invention may be, as mentioned above, a film consisting of only the first resin layer, that is a single-layer type film (see, Fig. 1), or a laminate type film which is consisting of the first resin layer 11 and other layer 15 (151-155) bonding to the first resin layer 11 (see, Figs. 2 to 5).

The other layer 15 may be a layer which gives at least one function selected from the group of hydrolysis resistance, water resistance (moisture resistance), light reflectivity, flame resistance, depending on the purpose or application. The other layer 15 may be a single layer, or consisting of two or more layers.

The constituent material of the other layer 15 may be a resin composition such as thermoplastic resin composition and hardened resin composition, an inorganic compound, a metal, and the like.

When the back surface protective film for solar cell of the present invention is a laminate type film, the thickness of the first resin layer and the total thickness of the other layers are, preferably from 5 to 600 μm and from 5 to 800 μm, and more preferably from 10 to 500 μm and from 8 to 700 μm, respectively.

Examples of the back surface protective film for solar cell of the present invention are as follows:

(1) a film having a reflectance to a light having a wavelength of 400 to 1,400 nm of 50% or higher when the light is irradiated to a surface of the first resin layer of the back surface protective film for solar cell (hereinafter, referred to as "film (I) of the present invention"); and

(2) a film including a first resin layer having a transmittance of a light having a wavelength of 800 to 1,400 nm of 60% or higher, and an absorbance of a light having a wavelength of 400 to 700 nm of 60% or higher (hereinafter, referred to as "film (II) of the present invention").

In the film (I) of the present invention, the reflectance to the light having a wavelength of 400 to 1,400 nm is measured at a time when the light is irradiated onto the surface of the first resin layer of the back surface protective film of the present invention, having a thickness of 10 to 1,000 μm. The reflectance is 50% or higher, preferably 60% or higher, and more preferably 70% or higher. Higher reflectance enables to reflect the light toward solar cell elements arranged in a filling unit, thereby enabling to improve a photoelectric conversion efficiency.

In the present invention, "the reflectance to the light having a wavelength of 400 to 1,400 nm is 50% or higher" means that an average value is 50% or higher which is calculated by once measuring reflectances to the lights at intervals of 20 nm over the wavelength range from 400 to 1,400 nm ascendingly from 400 nm or descendingly from 1,400 nm, and by utilizing the thus measured reflectances, however, it does not demand that the reflectances to the lights are 50% or higher throughout the wavelength range.

In the film (I) of the present invention, when the light having a wavelength of 400 to 1,400 nm is irradiated only to a film which has a thickness of 5 to 1,000 μm and is consisting of the first resin layer, the reflectance to this light is preferably 50% or higher, more preferably 60% or higher, and further preferably 70% or higher.

In the film (I) of the present invention, in order to attain a reflectance to the light having a wavelength of 400 to 1,400 nm of 50% or higher, it is preferable that the surface of the first resin layer has an L value (brightness) of 60 or higher. It is thus preferable that the first thermoplastic resin composition for constituting the first resin layer for satisfying the above property is a thermoplastic resin composition containing a white-based coloring agent as the composition prepared by melt-kneading a first starting material composition containing the first thermoplastic resin and silane coupling agent.

Examples of the white-based coloring agent include titanium oxide, zinc oxide, calcium carbonate, barium sulfate, calcium sulfate, alumina, silica, $2PbCO_3 \cdot Pb(OH)_2$, [$ZnS + BaSO_4$], talc, gypsum, and the like. Among these, titanium oxide is preferable. The white-based coloring agent may be used singly or in combination of two or more types

thereof. The content of the white-based coloring agent in the first thermoplastic resin composition is preferably in the range from 1 to 45 parts by weight, more preferably from 3 to 40 parts by weight, and further preferably from 5 to 30 parts by weight based on 100 parts by weight of the first thermoplastic resin, from a viewpoint of reflectivity to the above light. Excessively larger content of the white-based coloring agent occasionally leads to deterioration of flexibility of the films (I) of the present invention.
It is noted that other coloring agent is further usable depending on the purpose or application insofar as the coloring agent does not lower the reflectance at the surface of the first resin layer of the film (I) of the present invention down to less than 50%. When the other coloring agent is used, the content thereof is usually 5 parts or less by weight based on 100 parts by weight of the first thermoplastic resin.
In the present invention, in the case where the reflectance to the above light is less than 50% at only a film constituting the first resin layer (for example, the case in which the first resin layer contains no white-based coloring agent) in a multi-layer type film 1B comprising the first resin layer 11 and other layer 15 as shown in Fig. 2, when the constituent material of the other layer 15 is selected, the film (I) of the present invention may be obtained which has a reflectance to a light having a wavelength of 400 to 1,400 nm at the surface of the first resin layer of 50% or higher, thereby enabling to improve a photoelectric conversion efficiency.
The film (I) of the present invention is excellent in reflectance to the light related to photoelectric conversion in both cases that the film (I) is a single-layer type film and that the film (I) is a multi-layer type film. Therefore, when the solar light leaks through gaps among adjacent solar cell elements toward the back surface protective film for solar cell, the solar light is reflected by the first resin layer to supply the reflected light to the back surfaces of the solar cell elements and utilize the reflected light for photoelectric conversion, thereby enabling to improve a power generation efficiency.
In the film (II) of the present invention, the transmittance of the light having a wavelength of 800 to 1,400 nm and the absorbance of the light having a wavelength of 400 to 700 nm are measured at a time when the lights are separately irradiated to the surface of the first resin layer, i.e., to the surface of a single-layer type film (first resin layer only) having a thickness of 10 to 1,000 $\mu$m, or only to a film that constitutes a first resin layer in a multi-layer type film and has a thickness of 5 to 1,000 $\mu$m.
The transmittance is 60% or higher, preferably 65% or higher, and more preferably 70% or higher. Higher transmittance enables to restrict a heat storage at the first resin layer due to the light having a wavelength of 800 to 1,400 nm, thereby enabling to also restrict heat storage of a filling unit adhered to the first resin layer. This enables to restrict heat storage in a solar cell module to be formed using the film (II), thereby improving a power generation efficiency.
In the present invention, "the transmittance of the light having a wavelength of 800 to 1,400 nm is 60% or higher" means that an average value is 60% or higher which is calculated by once measuring transmittances of the light over the wavelength range from 800 to 1,400 nm at intervals of 20 nm ascendingly from 800 nm or descendingly from 1,400 nm for a film constituting the first resin layer, and by utilizing the thus measured transmittances, however, it does not demand that the transmittances of the light are 60% or higher throughout the wavelength range.
Further, in the film (II) of the present invention, the absorbance of the above light for the film constituting the first resin layer is 60% or higher, preferably 70% or higher, and more preferably 80% or higher. Higher absorbance lowers the brightness of the film constituting the first resin layer, thereby forming the first resin layer into a dark-colored one. Namely, the first resin layer allows for formation of a dark-colored back surface protective film for solar cell. This embodiment leads to an excellent external appearance of a solar cell when the solar cell is provided on a roof of a house or the like.
In the present invention, "the transmittance of the light having a wavelength of 400 to 700 nm is 60% or higher" means that an average value is 60% or higher which is calculated by once measuring absorbances of the light over the wavelength range from 400 to 700 nm at intervals of 20 nm ascendingly from 400 nm or descendingly from 700 nm for a film constituting the first resin layer, and by utilizing the thus measured absorbances, however, it does not demand that the absorbances of the light are 60% or higher throughout the wavelength range.
In the film (II) of the present invention, in order to attain a transmittance of the light having a wavelength of 800 to 1,400 nm of 60% or higher and an absorbance of the light having a wavelength of 400 to 700 nm of 60% or higher both at the film constituting the first resin layer, it is preferable for the film constituting the first resin layer to possess a property to absorb visible light therein and transmit infrared light therethrough.
It is thus preferable that the first thermoplastic resin composition constituting the first resin layer for satisfying the above-mentioned properties, is one formed by melt-kneading a first starting material composition containing a first thermoplastic resin, a silane coupling agent, and a coloring agent (hereinafter, referred to as "infrared transmissible coloring agent") having such a property to absorb visible light therein and to transmit infrared light therethrough.
The infrared transmissible coloring agent is usually in a color other than white, and is preferably a dark-colored compound colored in black, brown, dark blue, dark green, or the like. A dark-colored infrared transmissible coloring agent enables to provide a back surface protective film for solar cell having an excellent dark-colored external appearance without deteriorating adhesiveness between the first resin layer and an exposed surface of a filling unit, and a solar cell module having the back surface protective film.

Examples of the infrared transmissible coloring agent include a perylene-based pigment and the like. The following compounds represented by the general formulae (2) to (4) may be used as the perylene-based pigment.

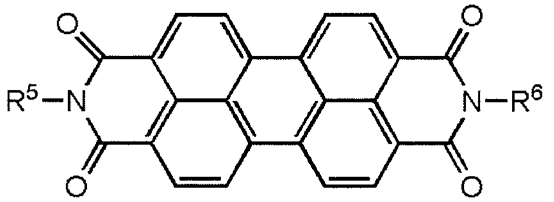

(2)

(In the formula, $R^5$ and $R^6$ may be the same or different from each other, and are butyl group, phenylethyl group, methoxyethyl group, or 4-methoxyphenylmethyl group.)

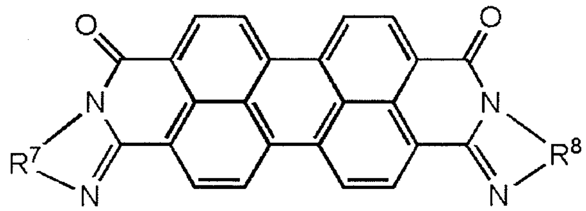

(3)

(In the formula, $R^7$ and $R^8$ may be the same or different from each other, and are phenylene group, 3-methoxyphenylene group, 4-methoxyphenylene group, 4-ethoxyphenylene group, an alkylphenylene group having 1-3 carbon atoms, hydroxyphenylene group, 4,6-dimethylphenylene group, 3,5-dimethylphenylene group, 3-chlorophenylene group, 4-chlorophenylene group, 5-chlorophenylene group, 3-bromophenylene group, 4-bromophenylene group, 5-bromophenylene group, 3-fluorophenylene group, 4-fluorophenylene group, 5-fluorophenylene group, naphhtylene group, naphthalene diyl group, pyridylene group, 2,3-pyridine diyl group, 4-methyl-2,3-pyridine diyl group, 5-methyl-2,3-pyridine diyl group, 6-methyl-2,3-pyridine diyl group, 5-methyl-3,4-pyridine diyl group, 4-methoxy-2,3-pyridine diyl group,or 4-chloro-2,3-pyridine diyl group.)

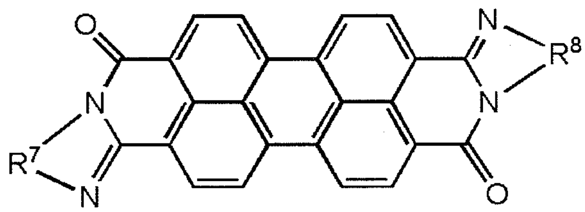

(4)

(In the formula, $R^7$ and $R^8$ may be the same or different from each other, and are phenylene group, 3-methoxyphenylene group, 4-methoxyphenylene group, 4-ethoxyphenylene group, an alkylphenylene group having 1-3 carbon atoms, hydroxyphenylene group, 4,6-dimethylphenylene group, 3,5-dimethylphenylene group, 3-chlorophenylene group, 4-chlorophenylene group, 5-chlorophenylene group, 3-bromophenylene group, 4-bromophenylene group, 5-bromophenylene group, 3-fluorophenylene group, 4-fluorophenylene group, 5-fluorophenylene group, naphhtylene group, naphthalene diyl group, pyridylene group, 2,3-pyridine diyl group, 4-methyl-2,3-pyridine diyl group, 5-methyl-2,3-pyridine diyl group, 6-methyl-2,3-pyridine diyl group, 5-methyl-3,4-pyridine diyl group, 4-methoxy-2,3-pyridine diyl group,or 4-chloro-2,3-pyridine diyl group.)

Commercially available products such as "Paliogen Black S 0084", "Paliogen Black L 0086", "Lumogen Black FK4280" and "Lumogen Black FK4281" which are all manufactured by BASF Corp. can be used as the perylene-based pigment.

The infrared transmissible coloring agent may be used singly or in combination of two or more types thereof.

The content of the infrared transmissible coloring agent in the first thermoplastic resin composition is preferably 5 parts or less by weight, and more preferably in the range from 0.1 to 5 parts by weight based on 100 parts by weight of the first thermoplastic resin, from viewpoints of the transmittivity and absorptivity of the respective light.

It is noted that the first thermoplastic resin composition for the first resin layer in the film (II) of the present invention may

contain other coloring agent depending on the purpose or application insofar as the other coloring agent does not lower the transmittivity and absorptivity. When a yellowish pigment, bluish coloring pigment, or the like is used as the other coloring agent than the infrared transmissible coloring agent, solar cell modules having various external appearances can be established by the following combinations:

(1) Brown coloring by a combination of a black-based infrared transmissible coloring agent and a yellowish pigment; and
(2) Dark bluish coloring by a combination of a black-based infrared transmissible coloring agent and a bluish pigment.

When the other coloring agent is used, the content thereof in the first thermoplastic resin composition is usually 200 parts or less by weight, and preferably in the range from 0.01 to 100 parts by weight based on 100 parts by weight of the infrared transmissible coloring agent.

Known as the dark-colored coloring agent is carbon black. The carbon black absorbs a light having a wavelength in the infrared region. Thus, when the solar light leaks through gaps among adjacent solar cell elements toward the film (II) of the present invention, the temperature of the film tends to be increased and the temperature of the filling unit including solar cell elements may be raised to deteriorate a power generation efficiency. Adoption of the infrared transmissible coloring agent leads to an excellent design and durability without deteriorating the power generation efficiency.

In the case where the film (II) of the present invention is a single-layer type film 1A shown in Fig. 1, when the solar light leaks through gaps among adjacent solar cell elements toward the back surface protective film for solar cell, a light having a wavelength of 800 to 1,400 nm transmits through the first resin layer and heat storage due to the light is suppressed, thereby enabling to also restrict heat storage of a filling unit adhered to the first resin layer. This enables to restrict heat storage in a solar cell module to be formed using the film (II), thereby improving a power generation efficiency. Therefore, in the case where the film (II) is separately combined with a member having a light reflectivity to establish into a solar cell module, when a part of the reflected solar light, from the above-mentioned member, which has leaked through gaps among adjacent solar cell elements and has transmitted through the first resin layer, is supplied to the back surface of the solar cell while transmitting the reflected light through the first resin layer, the reflected light is utilized to improve a power generation efficiency.

On the other hand, in the case where the film (II) of the present invention is a multi-layer type film shown in Fig. 2, i.e., is the film 1B comprising the first resin layer 11 and the other layer 15, when a light reflectivity is, for example, provided to the other layer 15, a part of the reflected solar light, from the above-mentioned member, which has leaked through gaps among adjacent solar cell elements and has transmitted through the first resin layer, is supplied to the back surface of the solar cell while transmitting the reflected light through the first resin layer, the reflected light is utilized to improve a power generation efficiency.

In the case where the film (II) of the present invention is a multi-layer type film, it is preferable that the transmittance of the light having a wavelength of 800 to 1,400 nm is 60% or higher, and the absorbance of the light having a wavelength of 400 to 700 nm is 60% or higher both at the first resin layer, and that the reflectance to the light having a wavelength of 800 to 1,400 nm is 50% or higher when this light is irradiated to a surface of the first resin layer of the back surface protective film for solar cell. Such configuration leads to a film having a dark-colored external appearance and an excellent external appearance, thereby enabling to restrict deformation of constituent members represented by the back surface protective film itself upon impingement of the solar light on the film, and to improve a power generation efficiency.

When the film (II) is realized, the other layer is preferably a resin layer which is consisting of a thermoplastic resin composition or a hardened resin composition, and the resin layer is preferably a white resin layer. And a composition constituting the white resin layer preferably contains a white-based coloring agent. In the present invention, in the case where the composition is a thermoplastic resin composition and the thermoplastic resin composition contains a white-based coloring agent, the explanation for the first thermoplastic resin composition is applied to the type of the white-based coloring agent and the content based on the thermoplastic resin.

When the back surface protective film of the present invention is a multi-layer type film comprising a first resin layer and other layer, it is preferable that the other layer is a resin layer comprising a thermoplastic resin composition (hereinafter, referred to as "other thermoplastic resin composition") containing a thermoplastic resin (hereinafter, referred to as "other thermoplastic resin") from viewpoints of productivity, flexibility, workability, optical characteristics such as reflectivity, and the like.

The film 1B shown in Fig. 2 is a double-layer type film having a first resin layer 11 and a resin layer (other layer 15) bonded to the first resin layer 11.

The other thermoplastic resin is not particularly limited so long as the resin has a thermoplasticity and the exemplified thermoplastic resin in the description for the first thermoplastic resin can be used. The resin may be used singly or in combination of two or more types thereof. Among these, a rubber reinforced aromatic vinyl-based resin, a polyester-based resin and an olefin-based resin are preferable in the present invention. Particularly preferred is a rubber

reinforced aromatic vinyl-based resin. When the other thermoplastic resin contains a rubber reinforced aromatic vinyl-based resin, hydrolysis resistance, dimensional stability and impact resistance are excellent.

The other thermoplastic resin composition may be a composition consisting of only the other thermoplastic resin, a composition containing the other thermoplastic resin and an additive, or a composition containing the other thermoplastic resin, a silane coupling agent and an additive. Contents of the additive and silane coupling agent may be the same as those for the first thermoplastic resin composition.

In the case where the back surface protective film for solar cell of the present invention is a double-layer type film 1B shown in Fig. 2, the production method of the film 1B is not particularly limited and is selected depending on the constituent material of the other layer 15. When the constituent material is other thermoplastic resin composition, examples of the production method include a coextrusion method such as T-die cast film forming method using the first thermoplastic resin composition and the other thermoplastic resin composition; a thermal fusion bonding method or dry lamination method using a film obtained using the first thermoplastic resin composition, a film which is obtained using the other thermoplastic resin composition and is intended to constitute the other layer 15; and the like. It is also possible to join a film obtained using the first thermoplastic resin composition to a film which is intended to constitute the other layer 15, with an adhesive consisting of a polyurethane-based resin composition, an epoxy resin composition, an acrylic resin composition, or the like.

Examples of the film intended to constitute the other layer 15 include a film which is formed with a thermoplastic resin composition containing a polyester-based resin (hereinafter, referred to as "polyester film"), a water vapor barrier layer forming film to be described later, and the like. Examples of the polyester film include a polyethylene terephthalate film, a polyethylene naphthalate film, a polybutylene terephthalate film, and the like. The other layer 15 may be formed with a commercially available product. Example thereof includes "Melinex 238" (trade name) manufactured by Teijin DuPont Films Japan Ltd., "SR 55" (trade name) manufactured by SKC Co., Ltd., "Lumiler X10P", "Lumiler ZV10", "Lumiler X10S" and "Lumiler E20" (trade name) manufactured by Toray Ind., Inc., and the like. When these products are used, scratch resistance may be given on the surface of the other layer 15.

In the case where the back surface protective film for solar cell is a double-layer type film 1B as shown in Fig. 2 and the other layer 15 is a hardened resin composition, an inorganic compound, a metal, or the like, the film 1B can be produced by a method such as a thermal fusion bonding method, a vapor deposition method, and a sputtering method.

When the back surface protective film of the present invention is a double-layer type film 1B as shown in Fig. 2, the thickness of the first resin layer 11 and that of the other layer 15 are preferably from 10 to 500 μm and from 5 to 500 μm, more preferably from 15 to 400 μm and from 8 to 400 μm, and further preferably from 20 to 300 μm and from 10 to 300 μm, respectively.

As mentioned above, when the back surface protective film for solar cell of the present invention is a laminate type film, the other layer 15 may be of two or more layers. Examples of the films are shown in Figs. 3 to 5.

The film 1C shown in Fig. 3 is a film having a first resin layer 11, a metal layer 151, and a resin layer 153, sequentially. The metal layer 151 and resin layer 153 constitute the other layer 15.

The film 1D shown in Fig. 4 is a film having a first resin layer 11, a resin layer 152, and a resin layer 153, sequentially. The resin layer 152 and resin layer 153 constitute the other layer 15.

In the three-layer type film 1D shown in Fig. 4, the resin layer 152 and resin layer 153 are to be configured to function as the second resin layer acting as a base layer in the back surface protective film for solar cell of the present invention, and as the third resin layer for providing the back surface protective film for solar cell of the present invention with a heat resistance and/or flexibility, respectively.

Assuming that constituent materials of the second resin layer and third resin layer are a second thermoplastic resin composition containing a second thermoplastic resin and a third thermoplastic resin composition containing a third thermoplastic resin, respectively, these resin compositions preferably have a film formability.

In order to provide the back surface protective film for solar cell of the present invention with heat resistance and flexibility by using the first thermoplastic resin composition, second thermoplastic resin composition, and third thermoplastic resin composition, glass transition temperature (Tg) of the first thermoplastic resin and Tg of the third thermoplastic resin are equal to or lower than Tg of the second thermoplastic resin. In order to provide a sufficient flexibility, Tg of the first thermoplastic resin and Tg of the third thermoplastic resin are lower than Tg of the second thermoplastic resin. The difference between Tg of the first thermoplastic resin and Tg of the second thermoplastic resin is preferably 10°C or more, and more preferably 15°C or more. The difference between Tg of the second thermoplastic resin and Tg of the third thermoplastic resin is preferably 10°C or more, and more preferably 15°C or more.

When plural Tg are detected in a chart by a differential scanning calorimeter (DSC) because two or more types of thermoplastic resins are contained in one resin layer, the highest temperature among the plural Tg is to be adopted as the applicable Tg.

Examples of the preferable first thermoplastic resin contained in the first thermoplastic resin composition, as mentioned above, include a rubber reinforced aromatic vinyl-based resin, a polyester-based resin and an olefin-based resin. Tg of the first thermoplastic resin is particularly in the range from 110°C to 140°C, from a viewpoint of provision

of the back surface protective film for solar cell of the present invention with flexibility and heat resistance.

The glass transition temperature (Tg) of the second thermoplastic resin is preferably 120°C or higher, more preferably from 120°C to 220°C, further preferably from 130°C to 190°C, more further preferably from 140°C to 170°C, and particularly from 145°C to 160°C, from a viewpoint to provide the back surface protective film for solar cell of the present invention with sufficient flexibility and heat resistance in the second resin layer, and from a viewpoint to restrict: a problem in case of applying a print, surface treatment, or the like to the third resin layer or to a layer to be provided at a back surface side of the third resin layer as required; heat shrinkage upon subjection to a temperature hysteresis; and the like.

The second thermoplastic resin is not particularly limited so long as the resin has a thermplasticity and example thereof includes an aromatic vinyl-based resin, a polyolefin-based resin, a poly vinyl chloride-based resin, a poly vinylidene chloride-based resin, a poly vinyl acetate-based resin, a saturated polyester-based resin, a polycarbonate resin, an acrylic resin, a fluoro resin, an ethylene vinyl acetate-based resin and the like. These resins may be used singly or in combination of two or more types thereof.

The exemplified thermoplastic resins in the description for the first thermoplastic resin can be used as the second thermoplastic resin.

The second thermoplastic resin is preferably an aromatic vinyl-based resin, a saturated polyester-based resin and an olefin-based resin. Particularly preferred is an aromatic vinyl-based resin. When the second thermoplastic resin contains an aromatic vinyl-based resin, hydrolysis resistance is excellent.

The second thermoplastic resin may be the same as or different from the first thermoplastic resin.

In order to provide the second resin layer with sufficient heat resistance, it is preferable that an aromatic vinyl-based resin is used as the second thermoplastic resin, and the resin contains a structural unit (u) derived from a maleimide-based compound. The structural unit (u) may be derived from a rubber reinforced aromatic vinyl-based resin contained in the aromatic vinyl-based resin, or from a (co)polymer that is blended as required. Further, the structural units may be derived from both of them.

The content of the structural unit (u) for the second resin layer excellent in heat resistance is preferably in the range from 1% to 50% by weight, more preferably from 5% to 45% by weight, and further preferably from 10% to 40% by weight, based on 100% by weight of the aromatic vinyl-based resin. If the content of the structural unit (u) is too much, flexibility of the second resin layer and the back surface protective film for solar cell of the present invention may be deteriorated.

The second thermoplastic resin composition is a composition which is consisting of the second thermoplastic resin, a composition which contains the second thermoplastic resin and an additive, or a composition which contains the second thermoplastic resin, a silane coupling agent and an additive. Content ratios of the additive and silane coupling agent may be the same as those in the first thermoplastic resin composition.

In the third resin layer, the glass transition temperature (Tg) of the third thermoplastic resin is preferably in the range from 90°C to 200°C, more preferably from 95°C to 160°C, further preferably from 95°C to 150°C, and particularly from 110°C to 140°C, from a viewpoint to provide the back surface protective film for solar cell of the present invention with sufficient flexibility, and from a viewpoint to provide the third resin layer with heat resistance.

The third thermoplastic resin is not particularly limited so long as the resin has a thermplasticity and example thereof includes an aromatic vinyl-based resin, a polyolefin-based resin, a poly vinyl chloride-based resin, a poly vinylidene chloride-based resin, a poly vinyl acetate-based resin, a saturated polyester-based resin, a polycarbonate resin, an acrylic resin, a fluoro resin, an ethylene vinyl acetate-based resin and the like. These resins may be used singly or in combination of two or more types thereof.

The exemplified thermoplastic resins in the description for the first thermoplastic resin can be used as the third thermoplastic resin.

The third thermoplastic resin is preferably an aromatic vinyl-based resin, a saturated polyester-based resin and an olefin-based resin. Particularly preferred is an aromatic vinyl-based resin. When the third thermoplastic resin contains an aromatic vinyl-based resin, hydrolysis resistance is excellent.

The third thermoplastic resin may be the same as or different from the first thermoplastic resin. Further, the third thermoplastic resin may be the same as or different from the second thermoplastic resin.

In order to provide the third resin layer with sufficient heat resistance, it is preferable that an aromatic vinyl-based resin is used as the third thermoplastic resin, and the resin contains a structural unit (u) derived from a maleimide-based compound. The structural unit (u) may be derived from a rubber reinforced aromatic vinyl-based resin contained in the aromatic vinyl-based resin, or from a (co)polymer that is blended as required. Further, the structural units may be derived from both of them.

The content of the structural unit (u) for the third resin layer excellent in heat resistance is preferably in the range from 1% to 40% by weight, more preferably from 3% to 35% by weight, and further preferably from 5% to 30% by weight, based on 100% by weight of the aromatic vinyl-based resin. If the content of the structural unit (u) is too much, flexibility of the third resin layer and the back surface protective film for solar cell of the present invention may be deteriorated.

The third thermoplastic resin composition is a composition which is consisting of the third thermoplastic resin, a composition which contains the third thermoplastic resin and an additive, or a composition which contains the third thermoplastic resin, a silane coupling agent and an additive. Content ratios of the additive and silane coupling agent may be the same as those in the first thermoplastic resin composition.

In the case where the back surface protective film for solar cell of the present invention is a three-layer type film 1D shown in Fig. 4, the production method of the film 1D is not particularly limited. Examples of the production method include a coextrusion method such as T-die cast film forming method using the first thermoplastic resin composition, second thermoplastic resin composition and third thermoplastic resin composition; a thermal fusion bonding method or dry lamination method or bonding method with an adhesive after fabricating three films using each thermoplastic resin composition; and the like.

Thicknesses of the first resin layer, second resin layer and third resin layer constituting the three-layer type film 1D shown in Fig. 4 are preferably in the range from 5 to 500 μm, from 10 to 990 μm, and from 5 to 500 μm, more preferably from 10 to 400 μm, from 20 to 500 μm, and from 10 to 400 μm, and further preferably from 20 to 350 μm, from 30 to 450 μm, and from 20 to 350 μm, respectively.

When the film (I) of the present invention is a three-layer type film consisting of the first resin layer, second resin layer and third resin layer, a white-based coloring agent is preferably contained in at least one resin layer among the first resin layer, second resin layer and third resin layer. All resin layers may contain a same white-based coloring agent, or different coloring agent from each other. The white-based coloring agent is preferably a titanium oxide.

When the first resin layer, second resin layer and third resin layer contain a white-based coloring agent, the content of the white-based coloring agent in each layer is preferably in the range from 1 to 45 parts by weight, more preferably from 3 to 40 parts by weight, and further preferably from 5 to 30 parts by weight based on 100 parts by weight of the first thermoplastic resin, 100 parts by weight of the second thermoplastic resin, or 100 parts by weight of the third thermoplastic resin, from a viewpoint of reflectivity to a light having a wavelength of 400 to 1,400 nm. The content of the white-based coloring agent is too much, flexibility of the film (I) of the present invention may be deteriorated.

It is noted that other coloring agent is further usable depending on the purpose or application insofar as the coloring agent does not lower the reflectance at the surface of the first resin layer of the film (I) of the present invention down to less than 50%. When the other coloring agent is used, the content thereof in each layer is usually 5 parts or less by weight based on 100 parts by weight of the first thermoplastic resin, 100 parts by weight of the second thermoplastic resin, or 100 parts by weight of the third thermoplastic resin.

In the three-layer type film, the measured L value at only the first resin layer is particularly 60 or more. Therefore, the first resin layer is preferably a white resin layer containing a white-based coloring agent in the three-layer type film.

In the case where the first resin layer contains a white-based coloring agent in the three-layer type film, the reflectance when a light having a wavelength of 400 to 1,400 nm is irradiated to a film comprising the first resin layer having a thickness of 5 to 500 μm, is preferably 50% or higher. In this case, the configurations and properties such as transparency and colorability of the second resin layer and third resin layer are not particularly limited.

The second resin layer and third resin layer may be white resin layers for the purpose of ensuring a reflectance to the above light at the surface of the first resin layer, or the like. The white resin layer may be one colored with a white-based coloring agent. The second resin layer and third resin layer may not a white resin layer and at least one of the second resin layer and third resin layer may be colored in a dark color. When the second resin layer and/or third resin layer contain(s) other coloring agent, each content of the other coloring agent in the second thermoplastic resin composition and third thermoplastic resin composition constituting the second resin layer and third resin layer is preferably in the range from 0.01 to 10 parts by weight, and more preferably from 0.05 to 5 parts by weight based on 100 parts by weight of the second thermoplastic resin and 100 parts by weight of the third thermoplastic resin.

When the first resin layer is a white resin layer and the reflectance to a light having a wavelength of 400 to 1,400 nm is lower than 50% at only a film constituting the first resin layer, the second resin layer and/or third resin layer is preferably a resin layer containing a white-based coloring agent. The each content of the white-based coloring agent in this case is preferably in the range from 5 to 40 parts by weight, and more preferably from 10 to 35 parts by weight, based on 100 parts by weight of the second thermoplastic resin and 100 parts by weight of the third thermoplastic resin, from a viewpoint of the reflectivity to the above light at the surface of the first resin layer.

When the first resin layer is a resin layer containing a white-based coloring agent, and the reflectance to a light having a wavelength of 400 to 1,400 nm is lower than 50% at only a film constituting the first resin layer, it is preferable that the second resin layer contains a white-based coloring agent and the third resin layer contains other coloring agent for coloring into a dark color. In this case, the content of the white-based coloring agent in the first resin layer can be 1 part or less by weight based on 100 parts by weight of the first thermoplastic resin, the content of the white-based coloring agent in the second resin layer is preferably in the range from 5 to 50 parts by weight, and more preferably from 10 to 40 parts by weight based on 100 parts by weight of the second thermoplastic resin, and the content of the other coloring agent in the third resin layer is preferably in the range from 0.01 to 10 parts by weight, and more preferably from 0.02 to 5 parts by weight.

In the case where the first resin layer is not white resin layer in the three-layer type film, it is preferable that the first resin layer contains no other coloring agents and the second resin layer and/or third resin layer contain(s) a white-based coloring agent. When the second resin layer and/or third resin layer contain(s) a white-based coloring agent, the content thereof in each layer is preferably in the range from 5 to 40 parts by weight and more preferably from 10 to 35 parts by weight based on 100 parts by weight of the first thermoplastic resin and 100 parts by weight of the second thermoplastic resin, from a viewpoint of the reflectivity to the above light.

Preferable embodiments are described hereinafter in case that the three-layer type film consisting of the first resin layer, second resin layer, and third resin layer, is the film (I) of the present invention:

(I-1) A film in which the first resin layer is a layer obtained using a first thermoplastic resin composition which is prepared by melt-kneading a first starting material composition containing a first thermoplastic resin, a silane coupling agent and a white-based coloring agent, the second resin layer is a layer obtained using a second thermoplastic resin composition which is prepared by melt-kneading a second starting material composition containing a second thermoplastic resin and not containing a white-based coloring agent; and the third resin layer is a layer obtained using a third thermoplastic resin composition which is prepared by melt-kneading a third starting material composition containing a third thermoplastic resin and not containing a white-based coloring agent;
(I-2) A film in which the first resin layer is a layer obtained using a first thermoplastic resin composition which is prepared by melt-kneading a first starting material composition containing a first thermoplastic resin, a silane coupling agent and a white-based coloring agent, the second resin layer is a layer obtained using a second thermoplastic resin composition which is prepared by melt-kneading a second starting material composition containing a second thermoplastic resin and not containing a white-based coloring agent, and the third resin layer is a layer obtained using a third thermoplastic resin composition which is prepared by melt-kneading a third starting material composition containing a third thermoplastic resin and a white-based coloring agent;
(I-3) A film in which the first resin layer is a layer obtained using a first thermoplastic resin composition which is prepared by melt-kneading a first starting material composition containing a first thermoplastic resin, a silane coupling agent and a white-based coloring agent, the second resin layer is a layer obtained using a second thermoplastic resin composition which is prepared by melt-kneading a second starting material composition containing a second thermoplastic resin and a white-based coloring agent, and the third resin layer is a layer obtained using a third thermoplastic resin composition which is prepared by melt-kneading a third starting material composition containing a third thermoplastic resin and not containing a white-based coloring agent; and
(I-4) A film in which the first resin layer is a layer obtained using a first thermoplastic resin composition which is prepared by melt-kneading a first starting material composition containing a first thermoplastic resin, a silane coupling agent and a white-based coloring agent, the second resin layer is a layer obtained using a second thermoplastic resin composition which is prepared by melt-kneading a second starting material composition containing a second thermoplastic resin and a white-based coloring agent, and the third resin layer is a layer obtained using a third thermoplastic resin composition which is prepared by melt-kneading a third starting material composition containing a third thermoplastic resin and a white-based coloring agent.

When the film (II) of the present invention is a three-layer type film consisting of a first resin layer, second resin layer and third resin layer, it is preferable that the second resin layer and/or third resin layer is/are high in reflectivity to a light having a wavelength of 800 to 1,400 nm, because 60% or more of the light is transmitted through the first resin layer. Providing such a configuration, the light having a wavelength of 800 to 1,400 nm transmitted through the first resin layer can be utilized for photoelectric conversion. Namely, it is enough that the reflectance to the above-mentioned light is made to be at least 50% at a film constituting the second resin layer and/or a film constituting the third resin layer. Specifically, it is preferable that, when the light having the above wavelength is separately irradiated to a film having a thickness of 10 to 990 $\mu$m comprising the second resin layer and to a film having a thickness of 5 to 500 $\mu$m comprising the third resin layer, the total of the reflectances is 50% or higher, or any one of the reflectances is 50% or higher.
In order to obtain a three-layer type film having the above-mentioned performance, it is preferable that the second resin layer and/or third resin layer contain(s) a white-based coloring agent. The content of the white-based coloring agent in each layer is preferably in the range from 1 to 45 parts by weight, more preferably from 3 to 40 parts by weight, and further preferably from 5 to 30 parts by weight based on 100 parts by weight of the second thermoplastic resin and 100 parts by weight of the third thermoplastic resin, from a viewpoint of reflectivity to the above light. If the content of the white-based coloring agent is too much, the flexibility of the film (II) of the present invention may be deteriorated.
It is noted that the second resin layer and/or third resin layer may contain other coloring agent depending on the purpose or application insofar as the coloring agent does not considerably deteriorate the reflectivity to the above light. When the other coloring agent is used, the each content thereof is usually 10 parts or less by weight based on 100 parts by weight of the second thermoplastic resin, and 100 parts by weight of the third thermoplastic resin. In this case, it is preferable that the first resin layer substantially does not contain a white-based coloring agent, however, if the first resin

layer contains a white-based coloring agent, the upper limit of the content thereof is usually 3 parts by weight and preferably 1 part by weight.

The embodiment of the three-layer type film may be one in which the first resin layer and second resin layer each contain an infrared transmissible coloring agent, and the third resin layer contains a white-based coloring agent.

Preferable embodiments are described hereinafter in case that the three-layer type film consisting of the first resin layer, second resin layer, and third resin layer, is the film (II) of the present invention:

(II-1) A film in which the first resin layer is a layer obtained using a first thermoplastic resin composition which is prepared by melt-kneading a first starting material composition containing a first thermoplastic resin, a silane coupling agent and an infrared transmissible coloring agent, the second resin layer is a layer obtained using a second thermoplastic resin composition which is prepared by melt-kneading a second starting material composition containing a second thermoplastic resin and not containing a white-based coloring agent, and the third resin layer is a layer obtained using a third thermoplastic resin composition which is prepared by melt-kneading a third starting material composition containing a third thermoplastic resin and a white-based coloring agent;

(II-2) A film in which the first resin layer is a layer obtained using a first thermoplastic resin composition which is prepared by melt-kneading a first starting material composition containing a first thermoplastic resin, a silane coupling agent and an infrared transmissible coloring agent, the second resin layer is a layer obtained using a second thermoplastic resin composition which is prepared by melt-kneading a second starting material composition containing a second thermoplastic resin and a white-based coloring agent, and the third resin layer is a layer obtained using a third thermoplastic resin composition which is prepared by melt-kneading a third starting material composition containing a third thermoplastic resin and not containing a white-based coloring agent; and

(II-3) A film in which the first resin layer is a layer obtained using a first thermoplastic resin composition which is prepared by melt-kneading a first starting material composition containing a first thermoplastic resin, a silane coupling agent and an infrared transmissible coloring agent, the second resin layer is a layer obtained using a second thermoplastic resin composition which is prepared by melt-kneading a second starting material composition containing a second thermoplastic resin and a white-based coloring agent, and the third resin layer is a layer obtained using a third thermoplastic resin composition which is prepared by melt-kneading a third starting material composition containing a third thermoplastic resin and a white-based coloring agent.

When the back surface protective film of the present invention is a three-layer type film as mentioned above, it is preferable that the first thermoplastic resin contained in the first resin layer, the second thermoplastic resin contained in the second resin layer, and the third thermoplastic resin contained in the third resin layer are of the same kind. Particularly preferable is an aromatic vinyl-based resin, and containment thereof leads to the film excellent in hydrolysis resistance, dimensional stability and impact resistance. In this case, the content ratios of a rubbery polymer contained in the respective resin layers may be the same or may be different from one another.

The embodiment of the back surface protective film of the present invention, except for the films (I) and (II), may be one in which the first resin layer contains no coloring agents, the second resin layer contains an infrared transmissible coloring agent, and the third resin layer contains a white-based coloring agent.

When the back surface protective film for solar cell of the present invention is a multi-layer type film, the other layer 15 may include a water vapor barrier layer. This water vapor barrier layer is typically arranged at a side which is opposite, with respect to the first resin layer, to a filling unit (not shown) embedding solar cell elements therein, in such a sequence of: a configuration including a filling unit, a first resin layer 11, and a water vapor barrier layer 15 (consisting of a metal layer 151 and a resin layer 153) (see, Fig. 3); a configuration including a filling unit embedding solar cell elements therein, a first resin layer, a second resin layer, and a water vapor barrier layer; a configuration including a filling unit embedding solar cell elements therein, a first resin layer, a second resin layer, a third resin layer, and a water vapor barrier layer; a configuration including a filling unit embedding solar cell elements therein, a first resin layer, a water vapor barrier layer, and a second resin layer; a configuration including a filling unit embedding solar cell elements therein, a first resin layer, a second resin layer, a water vapor barrier layer, and a third resin layer (see, Fig. 5); and the like.

Figs. 3 and 5 are examples of the back surface protective film for solar cell of the present invention including a water vapor barrier layer.

The film 1C shown in Fig. 3 is a film including sequentially the first resin layer 11 and the water vapor barrier layer consisting of the metal layer 151 and the resin layer 153, or a film including sequentially the first resin layer 11, the water vapor barrier layer consisting of the metal layer 151, and the resin layer 153.

Additionally, the film 1E shown in Fig. 5 is a film including the first resin layer 11, the (second) resin layer 152, the (third) resin layer 153, the water vapor barrier layer 154, and the resin layer 155, sequentially.

The water vapor barrier layer is a layer having such a performance that its water-vapor permeability (also called "water vapor transmission rate") measured under a condition of a temperature of 40°C and a humidity of 90%RH in accordance with JIS K7129, is preferably 3 g/($m^2$·day) or less, more preferably 1 g/($m^2$·day) or less, and further preferably

0.7 g/($m^2$·day) or less.

The water vapor barrier layer is preferably a layer comprising a material having an electric insulation property.

The water vapor barrier layer may have a single-layer structure consisting of one material, or a multi-layer structure, and the water vapor barrier layer may have a single-layer structure consisting of two or more materials, or a multi-layer structure. In the present invention, it is preferable that an evaporated film in which a film layer consisting of a metal and/or a metal oxide is formed on the surface, is used as a water vapor barrier layer-forming material, to thereby form the water vapor barrier layer. The metal and metal oxide may each be a single substance or two or more kinds of substances.

The water vapor barrier layer-forming material may be a three-layer type film in which a layer consisting of a metal and/or metal oxide is arranged between an upper resin layer and a lower resin layer.

Examples of the metal include aluminum, and the like.

Examples of the metal oxide include an oxide of an element such as silicon, aluminum, magnesium, calcium, potassium, tin, sodium, boron, titanium, lead, zirconium and yttrium. Among them, silicon oxide, aluminum oxide, and the like are particularly preferable, from a viewpoint of water vapor barrier property.

The layer consisting of the metal and/or metal oxide may be formed by a method such as plating, vacuum deposition, ion plating, sputtering, plasma CVD and microwave CVD. It is possible to combine two or more methods with each other.

Examples of the resin layer in the evaporated film include a polyester film comprising a polyethylene terephthalete, polyethylene naphthalate, and the like; a polyolefin film comprising a polyethylene, polypropylene, and the like; a poly vinylidene chloride film; a poly vinyl chloride film; a fluoro resin film; a polysulfone film; a polystyrene film; a polyamide film; a polycarbonate film; a polyacrylonitrile film; a polyimide film; and the like. The thickness of the resin layer is preferably in the range from 5 to 50 μm, and more preferably from 8 to 20 μm.

The water vapor barrier layer may be formed with a commercially available product. A film or sheet such as "TECBARRIER AX" manufactured by Mitsubishi Plastics Inc., "GX film" manufactured by Toppan Printing Co., Ltd., and "ECOSYAR VE500" manufactured by Toyobo Co., Ltd. can be used as the water vapor barrier layer forming material.

The water vapor barrier layer to be faced with the first resin layer is not particularly restricted in arrangement. In the case where a evaporated film is used as the water vapor barrier layer-forming material, a layer consisting of the metal and/or metal oxide may be bonded to the first resin layer, or the evaporated film may be arranged at an outer side (reverse surface side).

The thickness of the water vapor barrier layer is preferably in the range from 5 to 300 μm, more preferably from 8 to 250 μm, and further preferably from 10 to 200 μm. If the water vapor barrier layer is too thin, water vapor barrier property is not sufficient. On the other hand, if the water vapor barrier layer is too thick, the flexibility of the back surface protective film for solar cell of the present invention is not sufficient.

When the back surface protective film for solar cell of the present invention is provided with a water vapor barrier layer, it is possible to provide one side or both sides of the water vapor barrier layer with an adhesive layer for joining the water vapor barrier layer to another layer(s). The constituent material of the adhesive layer may be a polyurethane resin composition, an epoxy resin composition, an acrylic resin composition, and the like.

When the back surface protective film for solar cell of the present invention is a film consisting of a first resin layer 11 and a water vapor barrier layer 15 (See, Fig. 3), the combination of thicknesses of the first resin layer and the water vapor barrier layer is preferably in the range from 10 to 500 μm and in the range from 5 to 300 μm, more preferably from 15 to 400 μm and from 8 to 250 μm, and further preferably from 20 to 300 μm and from 10 to 200 μm, respectively.

When the back surface protective film for solar cell of the present invention is a laminate type film comprising two or more resin layers and a water vapor barrier layer, it is preferable that the back surface protective film for solar cell comprises a first resin layer, a second resin layer, a third resin layer, and a water vapor barrier layer. The combination of thicknesses of the first resin layer, second resin layer, third resin layer, and the water vapor barrier layer is preferably from 5 to 500 μm, from 10 to 985 μm, from 5 to 500 μm, and from 5 to 300 μm, more preferably from 10 to 400 μm, from 20 to 500 μm, from 10 to 400 μm, and from 8 to 250 μm, further preferably from 20 to 350 μm, from 30 to 450 μm, from 20 to 350 μm, and from 10 to 200 μm,, from viewpoints of flexibility, strength balance, and the like.

The production method of the film 1C shown in Fig. 3 is exemplified as follows:

(1) a method in which a first thermoplastic resin composition is used to prepare a single-layer type film in the same manner as above and then the single-layer type film is bonded to a water vapor barrier layer 15 forming material comprising a coat 151 consisting of a metal and/or metal oxide and a resin layer 153, by thermal fusion bonding or dry lamination, or with an adhesive; and

(2) a method in which a first thermoplastic resin composition is used to prepare a single-layer type film in the same manner as above and then a film consisting of a metal and/or metal oxide is formed on a surface of the single-layer type film, and subsequently the film layer consisting of a metal and/or metal oxide and other film prepared using a thermoplastic resin composition are joined by thermal fusion bonding or dry lamination, or with an adhesive.

In the case where the back surface protective film for solar cell of the present invention is a film comprising the first resin layer, second resin layer, third resin layer and water vapor barrier layer, the production method of the film is not particularly limited and is selected depending on a layer configuration, constituent materials of the respective layers, and the like. Examples of the production method include a method in which a first thermoplastic resin composition, a second thermoplastic composition and a third thermoplastic resin composition are subjected to coextrusion method or the like to form a laminate type film, and then the surface of the third layer in the laminate type film and a water vapor barrier layer forming material (film) are joined by thermal fusion bonding or dry lamination, or with an adhesive; and the like.

When the back surface protective film for solar cell of the present invention is a multi-layer type film, the other layer 15 may include a protective layer having a scratch resistance. This protective layer is typically arranged at a side opposite to the first resin layer in such a sequence of: a configuration comprising a filling unit embedding solar cell elements therein, a first resin layer, a second resin layer, a third resin layer, and the protective layer; a configuration comprising a filling unit embedding solar cell elements therein, a first resin layer, a second resin layer, a third resin layer, a water vapor barrier layer, and the protective layer (see, Fig. 5); and the like.

Fig. 5 is an example that shows a back surface protective film for solar cell of the present invention comprising a water vapor barrier layer and protective layer. The film 1E shown in Fig. 5 is a film which has the first resin layer 11, (second) resin layer 152, (third) resin layer 153, water vapor barrier layer 154, and protective layer 155, sequentially.

The protective layer is preferably a layer consisting of a composition (hereinafter, referred to as "fourth thermoplastic resin composition") containing a thermoplastic resin (hereinafter, referred to as "fourth thermoplastic resin"). The fourth thermoplastic resin is not particularly limited so long as the resin has a thermplasticity and example thereof includes a saturated polyester resin such as polyethylene terephthalate, polyethylene naphthalate and polybutylene terephthalate; a polyolefin resin such as polyethylene and polypropylene; a fluoro resin such as poly vinyl fluoride and ethylene tetrafluoroethylene copolymer; a polycarbonate resin; a polyamide resin; a poly arylate resin; a poly ether sulfone resin; a poly sulfone resin; a polyacrylonitrile; a cellulose resin such as cellulose acetate; an acrylic resin; an aromatic vinyl-based resin such as polystyrene and ABS resin; and the like. These resins may be used singly or in combination of two or more types thereof. Among these, a saturated polyester resin such as polyethylene terephthalate and a fluoro resin are preferable.

The fourth thermoplastic resin composition may be one containing an additive depending on purpose or application. Examples of this additive include a coloring agent, an antioxidant, an ultraviolet absorber, an anti-aging agent, a plasticizer, a fluorescent brightening agent, a weather resisting agent, a filler, an anti-static agent, a flame retardant, an anti-fogging agent, an anti-bacterial agent, a fungicide, an anti-fouling agent, a tackifier, a silane coupling agent, and the like.

The protective layer is preferably a resin layer having flame resistance. The protective layer may be a layer derived from a fourth thermoplastic resin composition containing a flame retardant, a layer derived from a composition containing an aromatic ring, a hetero atom, or the like in a molecule structure, or a layer in which an organic/inorganic hybrid material is laminated on one side or both side of a film consisting of a fourth thermoplastic resin composition (irrespectively of presence or absence of a flame retardant).

The preferable flame resistance of the protective layer is to exhibit a flammability in a class of VTM-2 or a class higher than it, in accordance with UL94 standards.

The protective layer may be formed using a commercially available product of a resin film having flame resistance. For example, a film of "Melinex 238" (trade name) manufactured by Teijin DuPont Films Japan Ltd., "SR 55" (trade name) manufactured by SKC Co., Ltd., "Lumiler X10P", "Lumiler X10S" and "Lumiler ZV10" (trade name) manufactured by Toray Ind., Inc., and the like can be used as a protective layer forming material.

The thickness of the protective layer is usually in the range from 10 to 500 μm, preferably from from 15 to 400 μm, and more preferably from 20 to 300 μm. Excessively thin protective layer occasionally leads to an insufficient scratch resistance. On the other hand, excessively thick protective layer occasionally leads to an insufficient flexibility as the back surface protective film for solar cell of the present invention.

When the back surface protective film for solar cell of the present invention is provided with the protective layer, this protective layer may be arranged via an adhesive layer. The material for the adhesive layer may be a polyurethane resin composition, an epoxy resin composition, an acrylic resin composition and the like.

When the back surface protective film for solar cell of the present invention is a film consisting of a first resin layer, a second resin layer, a third resin layer and a protective layer, the combination of thicknesses of the respective layers is preferably from 5 to 500 μm, from 10 to 980 μm, from 5 to 500 μm, and from 10 to 500 μm, more preferably from 10 to 400 μm, from 20 to 500 μm, from 10 to 400 μm, and from 15 to 400 μm, and further preferably from 20 to 350 μm, from 30 to 450 μm, from 20 to 350 μm, and from 20 to 300 μm, respectively.

Further, when the back surface protective film for solar cell of the present invention is a film consisting of a first resin layer, a second resin layer, a third resin layer, a water vapor barrier layer and a protective layer, the combination of thicknesses of the respective layers is preferably from 5 to 500 μm, 10 to 975 μm, 5 to 500 μm, 5 to 300 μm, and 10 to 500 μm, more preferably from 10 to 400 μm, 20 to 500 μm, 10 to 400 μm, 8 to 250 μm, and 15 to 400 μm, and further

preferably from 20 to 350 μm, 30 to 450 μm, 20 to 350 μm, 10 to 200 μm, and 20 to 300 μm, respectively. It is noted that the laminating sequence of the second resin layer, third resin layer and water vapor barrier layer is not limited.

When the back surface protective film for solar cell of the present invention is a film consisting of a first resin layer, a second resin layer, a third resin layer and a protective layer, the production method of the film is not particularly limited and is selected depending on a layer configuration, constituent materials of the respective layers, and the like. The production method thereof is exemplified as follows:

(1) a coextrusion method using a first thermoplastic resin composition, a second thermoplastic resin composition, a third thermoplastic resin composition, and a fourth thermoplastic resin (protective layer forming composition); and
(2) a method in which a first thermoplastic resin composition, a second thermoplastic resin composition and a third thermoplastic resin composition are subjected to coextrusion or the like to form a laminate type film and then the surface of the third resin layer in the laminate type film and a protective layer forming material (film) are joined by thermal fusion bonding or dry lamination, or with an adhesive.

When the back surface protective film for solar cell of the present invention is a film consisting of a first resin layer, a second resin layer, a third resin layer, a water vapor barrier layer and a protective layer, the production method thereof is exemplified as follows:

(1) a method in which a first thermoplastic resin composition, a second thermoplastic resin composition and a third thermoplastic resin composition are subjected to coextrusion or the like to form a laminate type film, and then the surface of the third resin layer in the laminate type film and a water vapor barrier layer forming material (film) are joined by thermal fusion bonding or dry lamination, or with an adhesive to form a water vapor barrier layer, subsequently a fourth thermoplastic resin composition (protective layer forming material) is used to form a protective layer on the water vapor barrier layer;
(2) a method in which a first thermoplastic resin composition, a second thermoplastic resin composition and a third thermoplastic resin composition are used in the same manner as above to form a laminate type film, and then the surface of the third resin layer in the laminate type film and a water vapor barrier layer forming material (film) are joined by thermal fusion bonding or dry lamination, or with an adhesive to form a water vapor barrier layer, subsequently the surface of the water vapor barrier layer and a protective layer forming material (film) are joined by thermal fusion bonding or dry lamination, or with an adhesive; and
(3) a method in which a protective layer forming material (film) and a water vapor barrier layer forming material (film) are joined by thermal fusion bonding or dry lamination, or with an adhesive to form a laminate type film, and then the surface of the water vapor barrier layer and the surface of the third resin layer of a laminate type film prepared using a first thermoplastic resin composition, a second thermoplastic resin composition and a third thermoplastic resin composition are joined by thermal fusion bonding or dry lamination, or with an adhesive.

The solar cell module of the present invention is characterized by including the back surface protective film for solar cell of the present invention. The schematic view of the solar cell module of the present invention is shown in Fig. 6. The solar cell module 2 of Fig. 6 may configure an obverse surface side transparent protective member 21, an obverse surface side sealing film (obverse surface side filling unit) 23, solar cell elements 25, a reverse surface side sealing film (reverse surface side filling unit) 27, and a back surface protective film for solar cell 1 of the present invention, disposed in this sequence from a light receiving face side (upper side in this figure) of the module for solar light.

The obverse surface side transparent protective member 21 is preferably consisting of a material excellent in water vapor barrier property; and a transparent substrate containing a glass, a resin, or the like is typically used. It is noted that, since glass is excellent in transparency and weathering resistance but is insufficient in impact resistance and is heavy, it is preferable to adopt a weather resistant transparent resin in case of establishing a solar cell to be placed on a roof of a house. Examples of the transparent resin include a fluorine-based resin and the like.

The thickness of the obverse surface side transparent protective member 21 is usually in the range from about 1 to 5 mm in case of adopting glass, and is usually in the range from about 0.1 to 5 mm in case of adopting a transparent resin.

The solar cell elements 25 each have a power generating function by receiving a solar light. Usable as such solar cell elements are known ones without particular limitations, insofar as they each have a function to exhibit a photoelectromotive force. Examples thereof include a crystalline silicon solar cell element such as single crystalline silicon type solar cell element and polycrystalline silicon type solar cell element; an amorphous silicon solar cell element having single bond type or tandem structure type; a III-V group compound semiconductor solar cell element such as gallium arsenide (GaAs) and indium phosphorus (InP); a II-VI group compound semiconductor solar cell element such as cadmium tellurium (CdTe) and copper indium selenide ($CuInSe_2$) ; and the like. Among these, a crystalline silicon solar cell element is preferable, and particularly preferred is a polycrystalline silicon type solar cell element. It is possible to adopt a hybrid element in which an amorphous silicon solar cell element and a thin-film polycrystalline silicon solar

cell element, a thin-film microcrystalline silicon solar cell element, or a thin-film crystalline silicon solar cell element are in combination; or the like.

Although not shown in Fig. 6, the solar cell element 25 is usually provided with a wiring electrode and a take-out electrode. The wiring electrode cooperatively has a function to collect electrons generated at multiple solar cell elements by receiving a solar light, and is connected to the solar cell element in a manner to couple the solar cell element at the obverse surface side sealing film (obverse surface side filling unit) 21 side, to the solar cell element at the reverse surface side sealing film (reverse surface side filling unit) 27 side, respectively, for example. Further, the take-out electrode cooperatively has a function to take out electrons collected by the wiring electrode or the like, as an electric current.

The obverse surface side sealing film (obverse surface side filling unit) 21 and the reverse surface side sealing film (reverse surface side filling unit) 27 (hereinafter, collectively referred to as "sealing films") are typically and previously formed into sheet-like or film-like sealing films by using the same sealing film forming material or mutually different ones, and by subsequently and thermally pressure jointing solar cell elements 25 and the like thereto, between the obverse surface side transparent protective member 21 and the back surface protective film for solar cell 1.

The thickness of each sealing film (filling unit) is usually in the range from about 100 μm to 4 mm, preferably from about 200 μm to 3 mm, and more preferably from about 300 μm to 2 mm. Excessively smaller thicknesses occasionally lead to damages of the solar cell elements 25, while excessively larger thicknesses disadvantageously lead to increased production costs.

The sealing film forming material is usually a resin composition or a rubber composition. Examples of the resin include an olefin-based resin, an epoxy resin, a poly vinyl butyral resin, and the like. Examples of the rubber include a silicone rubber, a hydrogenated conjugated diene-based rubber, and the like. Among these, an olefin-based resin and a hydrogenated conjugated diene-based rubber are preferable.

Examples of the olefin-based resin include a polymer by polymerization of an olefin or diolefin such as ethylene, propylene, butadiene and isoprene, a copolymer of ethylene and other monomer such as vinyl acetate and an acrylic ester, an ionomer, and the like. Specific example thereof includes a polyethylene, a polypropylene, a polymethylpentene, an ethylene vinyl chloride copolymer, an ethylene vinyl acetate copolymer, an ethylene (meth)acrylic acid ester copolymer, an ethylene vinylalcohol copolymer, a chlorinated polyethylene, a chlorinated polypropylene, and the like. Among these, an ethylene vinyl acetate copolymer and an ethylene (meth)acrylic acid ester copolymer are preferable. Particularly preferred is an ethylene vinyl acetate copolymer.

Examples of the hydrogenated conjugated diene-based rubber include a hydrogenated styrene butadiene rubber, a styrene-ethylenebutylene-olefin crystal block polymer, an olefin crystal-ethylenebutylene-olefin crystal block polymer, a styrene-ethylenebutylene-styrene block polymer, and the like. The preferable is a hydrogenated product of a conjugated diene block copolymer having the following structure, i.e., a block copolymer having at least two kinds of polymer blocks selected from: a polymer block A including an aromatic vinyl compound unit; a polymer block B obtained hydrogenating 80% or more by mol of double bond moieties of a polymer containing a conjugated diene-based compound unit where the content of 1,2-vinyl bond exceeds 25%; a polymer block C obtained hydrogenating 80% or more by mol of double bond moieties of a polymer containing a conjugated diene-based compound unit where the content of 1,2-vinyl bond is 25% or less; and a polymer block D obtained hydrogenating 80% or more by mol of double bond moieties of a copolymer containing an aromatic vinyl compound unit and a conjugated diene-based compound unit.

The sealing film forming material may contain, as required, an additive including a crosslinking agent, a crosslinking aid, a silane coupling agent, a ultraviolet abosorber, an antioxidant such as a hindered phenol and a phosphite, a photostabilizer based on a hindered amine, a light diffusing agent, a flame retardant, a discoloration inhibitor, and the like. As mentioned above, the material for forming the obverse surface side sealing film (obverse surface side filling unit) 23 may be the same as or different from the material for forming the reverse surface side sealing film (reverse surface side filling unit) 27. The former is preferably the same as the latter from a viewpoint of adhesiveness.

The solar cell module of the present invention can be produced by a lamination method, for example, configured to once arrange an obverse surface side transparent protective member, an obverse surface side sealing film, solar cell elements, a reverse surface side sealing film, and a back surface protective film for solar cell of the present invention in this order, and to subsequently heat and pressure joint them to one another while conducting vacuuming.

The temperature in laminating method is usually in the range from about 100°C to 250°C from a viewpoint of adhesiveness of the back surface protective film for solar cell of the present invention. Additionally, the lamination time is usually in the range from about 3 to 30 minutes.

[Examples]

Hereinafter, the present invention will be described in detail using Examples, however, the present invention is in no way limited by these Examples without departing from the scope of the invention. In the following, "part(s)" and "%" are based on mass unless otherwise indicated.

1. Evaluation method

Measuring methods of various evaluation items are as follows.

1-1. Rubber content in thermoplastic resin

It was calculated from a formulation upon charging of starting materials. 1-2. N-phenyl maleimide unit content in thermoplastic resin
It was calculated from a formulation upon charging of starting materials. 1-3. Glass-transition temperature (Tg)
It was measured with a differential scanning calorimeter "DSC2910" (type name) manufactured by TA Instruments in accordance with JIS K7121.

1-4. Peel strength

The back surface protective film for solar cell was cut into a strip shape (with a length of 200 mm, a width of 15 mm, and a thickness listed in the applicable Table) to prepare two films for evaluation. A film "Ultrapearl" (trade name, manufactured by Sanvic Inc.) which is made of an ethylene vinyl acetate copolymer and has a length of 100 mm, a width of 15 mm, and a thickness of 400 μm was arranged between the two films for evaluation, and the resultant assembly in the laminated state was brought into a laminator. After that, the laminator was brought into a vacuumed state at an upper portion and a lower portion thereof, and preheating was conducted at 150°C for 5 minutes. Subsequently, the upper portion was brought back to an atmospheric pressure, and then pressing was conducted for 15 minutes, to obtain a specimen for peel strength measurement.
The resultant specimen for peel strength measurement was used so that the films for evaluation were peeled from each other in a T-shaped manner from a location where they were not adhered to the EVA film, to measure a peel strength. Further, the peeled state was observed. The state at peeling was evaluated to be "2" where the EVA film was broken, and to be "1" where the specimen was broken at an interface between the EVA film and a part of the film for evaluation.

1-5. L value

The back surface protective film for solar cell (with a size of 50 mm X 50 mm, and a thickness listed in the applicable Table) was used as a measurement specimen, and an L value of a surface of the first resin layer of the back surface protective film was measured with a spectrophotometer "TCS-II" (type name) manufactured by Toyo Seiki Seisaku-Sho, Ltd.

1-6. Reflectances (%) to light having wavelength of 400 to 1,400 nm and light having wavelength of 800 to 1,400 nm

The back surface protective film for solar cell (with a size of 50 mm X 50 mm, and a thickness listed in the applicable Table) was used as a measurement specimen, and reflectances were measured with UV-VIS-NIR spectrophotometer "V-670" (type name) manufactured by JASCO Corp. Namely, the applicable light was irradiated onto a surface of the first resin layer of the measurement specimen to measure reflectances at intervals of 20 nm over the range from 400 nm or 800 nm to 1,400 nm, and calculate an average value of the reflectances.

1-7. Transmittance (%) of light having wavelength of 800 to 1,400 nm

A film for the first resin layer (with a size of 50 mm X 50 mm, and a thickness listed in the applicable Table) which was obtained using a first thermoplastic resin composition containing an infrared transmissible coloring agent (perylene-based black pigment) was used as a measurement specimen, and transmittance was measured with UV-VIS-NIR spectrophotometer "V-670" (type name) manufactured by JASCO Corp. Namely, the applicable light was irradiated onto the specimen to measure transmittance at intervals of 20 nm in the range from 800 nm to 1,400 nm, and calculate an average value of the transmittances.

1-8. Absorbance (%) of light having wavelength of 400 to 700 nm

A film for the first resin layer (with a size of 50 mm X 50 mm, and a thickness listed in the applicable Table) which was obtained using a first thermoplastic resin composition containing an infrared transmissible coloring agent (perylene-based black pigment) was used as a measurement specimen, and transmittances and reflectances were measured with UV-VIS-NIR spectrophotometer "V-670" (type name) manufactured by JASCO Corp. Namely, the applicable light was irradiated onto the specimen at intervals of 20 nm over the range from 400 nm to 700 nm to measure

transmittances and reflectances and calculates average values of the transmittances and reflectances. The absorbance was calculated by the following equation, based on the average value of the transmittances and the average value of the reflectances:

$$\text{Absorbance (\%)} = 100 - \{\text{transmittance (\%)} + \text{reflectance (\%)}\}$$

1-9. Retention rate of tensile strength (moist-heat aging test)

The back surface protective film for solar cell having a specified size was subjected to the following exposure test and tensile strengths of the film before and after the exposure were measured in accordance with JIS K7127, to calculate a ratio therebetween:

$$\text{Retention rate of tensile strength (\%)} = \{[\text{tensile strength (N/15mm) after exposure test}]/[\text{tensile strength (N/15mm) before exposure test}]\} \times 100$$

<Exposure test>

The back surface protective film for solar cell was cut into a strip shape (with a length of 200 mm, a width of 15 mm, and a thickness listed in the applicable Table 1), and the film was left to stand still for 2,000 hours under conditions of a temperature of 85°C and a humidity of 85%RH.

1-10. Dimensional stability

The back surface protective film for solar cell having a specified size was subjected to the following heating test and lengths of a reference line before and after of heating were measured to calculate a dimension change ratio:

$$\text{Dimension change ratio (\%)} = \{[(\text{length of reference line before heating}) - (\text{length of reference line after heating})]/(\text{length of reference line before heating})\} \times 100$$

The dimensional stability was judged based on the following criteria, from the calculated value:

3: dimension change ratio was less than 1%
2: dimension change ratio was 1% or more and less than 2%
1: dimension change ratio was 2% or more

<Heating test>

The back surface protective film for solar cell was cut into a square shape (120 mm X 120 mm), and a square reference line of 100 mm X 100 mm was drawn at a central portion of the square film. This film was left to stand still in a constant temperature bath at a temperature of 120°C for 30 minutes, was thereafter taken out of it, and was left to be cooled.

1-11. Improvement rate of photoelectric conversion efficiency

In a chamber conditioned to a temperature of 25°C±2°C and a humidity of 50±5%RH, Solar Simulator "PEC-11" (type name) manufactured by Peccell Technologies Inc. was used to produce a solar cell module. A glass having a thickness of 3 mm and a back surface protective film for solar cell were arranged on an obverse surface and a reverse surface, respectively, of a 1/4 polycrystalline silicon cell in which the photoelectric conversion efficiency of the cell itself having been measured in advance, in a manner to interpose the silicon cell between the glass and the back surface protective film for solar cell, and an EVA was then introduced into between the glass and the back surface protective film for solar cell to seal the silicon cell, thereby fabricating a solar cell module. Then, light was irradiated thereto, and

a photoelectric conversion efficiency was measured immediately thereafter so as to decrease an influence of temperature. Thus obtained photoelectric conversion efficiency and photoelectric conversion efficiency of the cell itself were used to obtain an improvement rate of photoelectric conversion efficiency:

Improvement rate of photoelectric conversion efficiency (%) = {(photoelectric conversion efficiency of module - photoelectric conversion efficiency of cell itself)/(photoelectric conversion efficiency of cell itself)} X 100

1-12. Water vapor barrier property

The water vapor transmission rate was measured with a water vapor permeability-measuring apparatus "PERMATRAN W3/31" (type name) manufactured by MOCON Inc. under conditions of a temperature of 40°C and a humidity of 90%RH in accordance with JIS K7129B. A surface, which was reverse to an associated first resin layer, was arranged as a transmission surface at a water vapor side.

1-13. Scratch resistance

A surface of the back surface protective film for solar cell, which was reverse to an associated first resin layer, was subjected to 500 times of a reciprocative friction by a cotton canvas cannequin No. 3, under a vertical load of 500 g using a dynamic rubbing tester manufactured by Tosoku Seimitsu Kogyo Ltd. The surface thereafter was observed by a visual inspection, and judged based on the following criteria:

3; no scratches were observed
2; a slight scratch was observed
1; scratches were clearly observed.

2. Starting materials for production of back surface protective film for solar cell

Starting materials used for preparation of thermoplastic resin compositions, and the like are as follows.

2-1. Acrylic rubber reinforced aromatic vinyl-based resin

50 parts (calculated as solid content) of latex having a solid content concentration of 40% containing an acrylic rubbery polymer (volume average particle size: 100 nm; gel content: 90%) obtained by emulsion polymerization of 99 parts of n-butyl acrylate and 1 part of allyl methacrylate was charged into a reaction vessel, and the latex was diluted by introducing thereinto 1 part of sodium dodecylbenzene sulfonate and 150 parts of ion exchange water. After that, the interior of the reaction vessel was purged with a nitrogen gas; 0.02 part of ethylenediamine tetraacetic acid disodium, 0.005 part of ferrous sulfate, and 0.3 part of sodium formaldehyde sulfoxylate were added and the mixture was heated to 60°C while stirring.
In turn, 50 parts of a mixture of 37.5 parts of styrene and 12.5 parts of acrylonitrile; 1.0 part of terpinolene; and 0.2 part of cumene hydroperoxide were charged into a container and the interior of the container was purged with a nitrogen gas to prepare a monomer composition.
Subsequently, the monomer composition was added into the reaction vessel at a constant flow rate over 5 hours in a manner to conduct polymerization at a temperature of 70°C, thereby obtaining a latex. Added into this latex was magnesium sulfate, to solidify the resin component. Thereafter, the solidified component was washed with water and dried, thereby obtaining an acrylic rubber reinforced aromatic vinyl-based resin. Graft ratio was 93%, and an intrinsic viscosity [η] was 0.30 dl/g (at 30°C, in methyl ethyl ketone). Further, its glass transition temperature (Tg) was 101°C.

2-2. Butadiene rubber reinforced aromatic vinyl-based resin

75 parts of ion exchange water, 0.5 part of potassium rosinate, 0.1 part of tert-dodecyl mercaptan, 32 parts (calculated as solid content) of a polybutadiene latex (volume average particle size: 270 nm; gel content: 90%), 8 parts (calculated as solid content) of styrene butadiene copolymer latex (styrene unit content: 25%; volume average particle size: 550 nm; gel content of 50%), 15 parts of styrene, and 5 parts of acrylonitrile were charged into a glass-made reaction vessel having a stirrer and the mixture was heated in a nitrogen gas stream, while stirring. When the interior

temperature reached 45°C, added into the mixture was an aqueous solution prepared by dissolving 0.2 part of sodium pyrophosphorate, 0.01 part of ferrous sulfate 7-hydrate, and 0.2 part of glucose, into 20 parts of ion exchange water. After that, 0.07 part of cumene hydroperoxide was added into the mixture to initiate polymerization at a temperature of 70°C, followed by polymerization for one hour.
Then, 50 parts of ion exchange water, 0.7 part of potassium rosinate, 30 parts of styrene, 10 parts of acrylonitrile, 0.05 part of tert-dodecyl mercaptane, and 0.01 part of cumene hydroperoxide were continuously added into the system, over 3 hours, to continue the polymerization. After polymerization for one hour, added into the mixture was 0.2 part of 2,2'-methylene-bis(4-ethylene-6-tert-butylphenol) to terminate the polymerization, thereby obtaining a latex.
Subsequently, magnesium sulfate was added into this latex, to solidify the resin component. Thereafter, the solidified component was washed with water and dried, thereby obtaining a butadiene rubber reinforced aromatic vinyl-based resin. Graft ratio was 72%, and an intrinsic viscosity [η] of an acetone soluble component was 0.47 dl/g. Further, the glass transition temperature (Tg) of the resin was 105°C.

2-3. Acrylonitrile styrene copolymer

AS resin "SAN-H" (trade name) manufactured by Techno Polymer Co., Ltd. was used. Its glass-transition temperature (Tg) is 108°C.

2-4. Acrylonitrile styrene N-phenyl maleimide copolymer

Acrylonitrile styrene N-phenyl maleimide copolymer "POLYIMILEX PAS1460" (trade name) manufactured by NIPPON SHOKUBAI CO., LTD. was used. The polymer has an N-phenyl maleimide unit in an amount of 40% and a styrene unit amount of 51%, and has an Mw of 120,000 determined relative to polystyrene standards by GPC. Its glass-transition temperature (Tg) is 173°C.

2-5. Polyethylene terephthalate

Polyethylene terephthalate "NOVAPEX GM700Z" (trade name) manufactured by Mitsybishi Chemical Corp. was used. Its glass-transition temperature (Tg) is 75°C.

2-6. Polypropylene

Polypropylene "EA9" (trade name) manufactured by Japan Polypropylene Corp. was used.

2-7. Silane coupling agent

The following three compounds were used.

(x) 3-methacryloxypropyl trimethoxysilane
(y) 3-glycidoxypropyl trimethoxysilane
(z) vinyl methoxysilane

2-8. White-based coloring agent

Titanium oxide "Tipaque CR-50-2" (trade name) manufactured by ISHIHARA SANGYO KAISHA, LTD. was used. Its averaged primary particle diameter is 0.25 μm.

2-9. Infrared transmissible coloring agent

Perylene-based black pigment "Lumogen BLACK FK4280" (trade name) manufactured by BASF Corp. was used.

2-10. Yellow coloring agent

Quinophthalone-based yellow pigment "Paliotol Yellow K0961HD" (trade name) manufactured by BASF Corp. was used.
Following water vapor barrier layer forming films and polyester films were used as films for forming other layers.

2-11. Water vapor barrier layer forming film (R-1)

Transparent vapor deposited film "TECBARRIER AX" (trade name) manufactured by Mitsubishi Plastics Inc. was used. It is a transparent film having a silica vapor deposited on one side of a PET film. The thickness thereof is 12 μm, and a water vapor transmission rate (JIS K7129) is 0.15 g/ ($m^2$·day).

2-12. Water vapor barrier layer forming film (R-2)

Two components vapor deposited barrier film "ECOSYAR VE500" (trade name) manufactured by TOYOBO Co., Ltd. was used. It is a transparent film having a vapor (silica/alumina) deposited on one side of a PET film. The thickness thereof is 12 μm, and a water vapor transmission rate is 0.5 g/($m^2$·day).

2-13. Resin layer forming film (F-1)

A white PET film "Lumiler E20" (trade name) manufactured by Toray Ind., Inc. was used. The thickness is 50 μm.

2-14. Resin layer forming film (F-2)

A PET film "Lumiler X10S" (trade name) manufactured by Toray Ind., Inc. was used. The thickness is 50 μm.

2-15. Resin layer forming film (F-3)

A PET film "Melinex 238" (trade name) manufactured by Teijin DuPont Films Japan Ltd. was used. The thickness is 75 μm.

3. Production and evaluation of back surface protective film for solar cell 3-1. Production and evaluation of single-layer type back surface protective film for solar cell

Example 1-1

A first starting material composition containing 30 parts of an acrylic rubber reinforced aromatic vinyl-based resin, 30 parts of an acrylonitrile styrene copolymer, 40 parts of an acrylonitrile styrene N-phenyl maleimide copolymer, 0.3 part of the silane coupling agent (x), and 20 parts of a white-based coloring agent were kneaded at a temperature of 250°C with Brabender kneader to obtain a first thermoplastic resin composition. After that, a T-die was used to form a single-layer type back surface protective film for solar cell (having a thickness of 400 μm) consisting of the first thermoplastic resin composition. Various evaluations were conducted for this back surface protective film for solar cell. The results are shown in Table 1.

Examples 1-2 to 1-9 and Comparative Examples 1-1 to 1-5

Single-layer type back surface protective films for solar cell were obtained in the same procedure as Example 1-1, except that the applicable components listed in Table 1 were adopted at predetermined ratios. Kneading temperatures and film thicknesses were shown in Table 1. Moreover, various evaluations were conducted for these back surface protective films for solar cell. The results are shown in Table 1.

[Table 1]

Table 1

| | | | Example | | | | | | | | | Comparative Example | | | | |
|---|---|---|---|---|---|---|---|---|---|---|---|---|---|---|---|---|
| | | | 1-1 | 1-2 | 1-3 | 1-4 | 1-5 | 1-6 | 1-7 | 1-8 | 1-9 | 1-1 | 1-2 | 1-3 | 1-4 | 1-5 |
| First thermoplastic resin composition | First starting material composition (part) | Acrylic rubber reinforced aromatic vinyl-based resin | 30 | 30 | 30 | | 30 | | | 30 | 30 | 30 | | | | 30 |
| | | Butadiene rubber reinforced aromatic vinyl-based resin | | | | 40 | | | | | | | 40 | | | |
| | | Acrylonitrile styrene copolymer | 30 | 30 | 30 | 20 | 30 | | | 30 | 30 | 30 | 20 | | | 30 |
| | | Acrylonitrile styrene N-phenyl maleimide copolymer | 40 | 40 | 40 | 40 | 40 | | | 40 | 40 | 40 | 40 | | | 40 |
| | | Polyethylene terephthalate | | | | | | 100 | | | | | | 100 | | |
| | | Polypropylene | | | | | | | 100 | | | | | | 100 | |
| | | Silane coupling agent (x) | 8 | 3 | 0.3 | 3 | | | | 0.3 | 0.3 | | | | | |
| | | Silane coupling agent (y) | | | | | 3 | 0.3 | | | | | | | | |
| | | Silane coupling agent (z) | | | | | | | 0.3 | | | | | | | |
| | | Titanium oxide | 20 | 20 | 15 | 20 | 20 | 15 | 15 | | | 20 | 15 | 15 | 15 | |
| | | Perylene-based black pigment | | | | | | | | 2 | 1 | | | | | 2 |
| | | Quinophthalone-based yellow pigment | | | | | | | | 1 | 0.5 | | | | | 1 |
| | Content | Rubber content *1 (%) | 15 | 15 | 15 | 16 | 15 | - | - | 15 | 15 | 15 | 16 | - | - | 15 |
| | | N-phenyl maleimide unit content *1 (%) | 16 | 16 | 16 | 16 | 16 | - | - | 16 | 16 | 16 | 16 | - | - | 16 |
| | Kneading temperature (°C) | | 250 | 250 | 250 | 250 | 250 | 270 | 190 | 250 | 250 | 250 | 250 | 270 | 190 | 250 |
| Back surface protective film for solar cell | Thickness (μm) | | 400 | 120 | 40 | 70 | 120 | 100 | 50 | 35 | 60 | 60 | 100 | 100 | 50 | 60 |
| | Evaluation | Peel strength (N) | 82 | 80 | 65 | 75 | 78 | 70 | 75 | 71 | 77 | 12 | 10 | 15 | 10 | 15 |
| | | State at peeling | 2 | 2 | 2 | 2 | 2 | 2 | 2 | 2 | 2 | 1 | 1 | 1 | 1 | 1 |
| | | L value | 95 | 92 | 61 | 82 | 91 | 89 | 68 | 15 | 21 | 84 | 79 | 88 | 66 | 16 |
| | | Reflectance (wavelength:400-1400nm) (%) | 82 | 70 | 55 | 60 | 70 | 73 | 58 | - | - | 58 | 69 | 70 | 58 | - |
| | | Transmittance (wavelength:800-1400nm) (%) | - | - | - | - | - | - | - | 82 | 89 | - | - | - | - | 81 |
| | | Absorbance (wavelength:400-700nm) (%) | - | - | - | - | - | - | - | 81 | 72 | - | - | - | - | 80 |
| | | Retention rate of tensile strength (%) | 99 | 97 | 98 | 94 | 96 | 2 | 91 | 93 | 94 | 99 | 94 | 3 | 92 | 93 |
| | | Dimensional stability | 3 | 3 | 3 | 3 | 3 | 3 | 2 | 3 | 3 | 3 | 3 | 3 | 2 | 3 |

*1 It is a content based on 100% by weight of a thermoplastic resin.

Apparent from the results in Table 1, the back surface protective films for solar cell according to Comparative Examples 1-1 to 1-5 adopting the first thermoplastic resin compositions obtained by kneading the first starting material compositions containing no silane coupling agents therein were low in peel strength to be 10 to 15 N for adhesion to the film consisting of an ethylene vinyl acetate copolymer, and thus were insufficient in adhesiveness.
On the other hand, the back surface protective films for solar cell according to Examples 1-1 to 1-9 adopting the first thermoplastic resin compositions obtained by kneading the first starting material compositions containing silane coupling agents blended therein were high in peel strength to be 65 to 82 N, and thus were excellent in adhesiveness.

3-2. Production and evaluation of double-layer type back surface protective film for solar cell

Example 2-1

Henschel Mixer was used to prepare a first starting material composition and a second starting material composition for forming a first resin layer and a second resin layer, respectively, as shown in Table 2. Thereafter, the compositions were each melted and kneaded with a twin-screw extruder (type name "TEX44" manufactured by The Japan Steel Works, LTD.) at a barrel temperature of 270°C, thereby obtaining two kinds of pellets constituting a first thermoplastic resin composition and a second thermoplastic resin composition, respectively.
Subsequently, a multi-layer type film forming machine provided with two extruders each comprising a T-die having a die width of 1,400 mm and a lip distance of 1.5 mm, and a screw of 65 mm diameter was used, and the first thermoplastic resin composition and the second thermoplastic resin composition were supplied to the extruders. Then, the molten resins were discharged from the T-dies at a temperature of 270°C, respectively, to form a double-layer type soft film. After that, this double-layer type soft film was cooled and solidified while being surface-contacted, by air knife, to a cast roll having a surface temperature controlled to be 95°C, to form a double-layer type back surface protective film for solar cell (white-white type) having a thickness of 400 μm. The thickness of the first resin layer and second resin layer were shown in Table 2. The thickness of the film was measured with a thickness gauge (type name "ID-C1112C" manufactured by Mitutoyo Corp.) and was an average value of those measured values which was obtained by once cutting a film piece out of the produced film after a lapse of one hour from commencement of production thereof, and by measuring thicknesses of the film piece at its widthwise center and at points (n=107) at intervals of 10 mm from the widthwise center toward both edges. The values at measured points within a range of 20 mm from each edge of the film piece were excluded from the calculation of the average value.
Various evaluations were conducted for this back surface protective film for solar cell. The results are shown in Table 2.

Examples 2-2 to 2-8 and Comparative Examples 2-1 to 2-5

Starting materials of compositions for forming first resin layers and second resin layers listed in Table 2 and Table 3 were used to obtain double-layer type back surface protective films for solar cell (white-white type) in the same manner as those in Example 2-1. Various evaluations were conducted for these back surface protective films for solar cell. The results are shown in Table 2 and Table 3.
[Table 2]

Table 2

| | | | Example | | | | Comparative Example | |
|---|---|---|---|---|---|---|---|---|
| | | | 2-1 | 2-2 | 2-3 | 2-4 | 2-1 | 2-2 |
| First resin layer | First starting material composition (part) | Acrylic rubber reinforced aromatic vinyl-based resin | 30 | 30 | 30 | | 30 | |
| | | Butadiene rubber reinforced aromatic vinyl-based resin | | | | 40 | | 40 |
| | | Acrylonitrile styrene copolymer | 30 | 30 | 30 | 20 | 30 | 20 |
| | | Acrylonitrile styrene N-phenyl maleimide copolymer | 40 | 40 | 40 | 40 | 40 | 40 |
| | | Silane coupling agent (x) | 8 | 3 | 0.3 | 3 | | |
| | | Titanium oxide | 20 | 20 | 15 | 20 | 20 | 20 |
| | Content | Rubber content *1 (%) | 15 | 15 | 15 | 16 | 15 | 15 |
| | | N-phenyl maleimide unit content *1 (%) | 16 | 16 | 16 | 16 | 16 | 16 |
| | Thickness (μm) | | 200 | 60 | 40 | 60 | 60 | 60 |
| Second resin layer | Second starting material composition (part) | Acrylic rubber reinforced aromatic vinyl-based resin | 30 | 30 | 30 | | 30 | |
| | | Butadiene rubber reinforced aromatic vinyl-based resin | | | | 40 | | 40 |
| | | Acrylonitrile styrene copolymer | 30 | 30 | 30 | 20 | 30 | 20 |
| | | Acrylonitrile styrene N-phenyl maleimide copolymer | 40 | 40 | 40 | 40 | 40 | 40 |
| | | Titanium oxide | 20 | 20 | 20 | 20 | 20 | 20 |
| | Content | Rubber content *1 (%) | 15 | 15 | 15 | 16 | 15 | 15 |
| | | N-phenyl maleimide unit content *1 (%) | 16 | 16 | 16 | 16 | 16 | 16 |
| | Thickness (μm) | | 200 | 60 | 30 | 60 | 60 | 60 |
| Back surface protective film for solar cell | | | | | | | | |
| | Thickness (μm) | | 400 | 120 | 70 | 120 | 120 | 120 |
| | Evaluation | Peel strength (N) | 81 | 80 | 57 | 81 | 13 | 10 |
| | | State at peeling | 2 | 2 | 2 | 2 | 1 | 1 |
| | | L value *2 | 87 | 80 | 72 | 80 | 84 | 79 |
| | | Reflectance (wavelength:400-1400nm) *2 (%) | 83 | 71 | 69 | 73 | 70 | 74 |
| | | Retention rate of tensile strength (%) | 98 | 97 | 98 | 97 | 99 | 94 |
| | | Dimensional stability | 3 | 3 | 3 | 3 | 3 | 3 |
| | | Improvement rate of photoelectric conversion efficiency (%) | 20 | 18 | 17 | 18 | 17 | 18 |

*1 It is a content based on 100% by weight of a thermoplastic resin in each layer.

*2 It is a measured value at the surface of the first resin layer.

[Table 3]

Table 3

| | | | Example | | | | Comparative Example | | |
|---|---|---|---|---|---|---|---|---|---|
| | | | 2-5 | 2-6 | 2-7 | 2-8 | 2-3 | 2-4 | 2-5 |
| First resin layer | First starting material composition (part) | Acrylic rubber reinforced aromatic vinyl-based resin | 30 | 30 | | | 30 | | |
| | | Butadiene rubber reinforced aromatic vinyl-based resin | | | | | | | |
| | | Acrylonitrile styrene copolymer | 30 | 30 | | | 30 | | |
| | | Acrylonitrile styrene N-phenyl maleimide copolymer | 40 | 40 | | | 40 | | |
| | | Polyethylene terephthalate | | | 100 | | | 100 | |
| | | Polypropylene | | | | 100 | | | 100 |
| | | Silane coupling agent (x) | 3 | | | | | | |
| | | Silane coupling agent (y) | | 3 | 0.3 | | | | |
| | | Silane coupling agent (z) | | | | 0.3 | | | |
| | | Titanium oxide | 20 | 20 | 15 | 15 | 20 | 15 | 15 |
| | Content | Rubber content *1 (%) | 15 | 15 | 0 | 0 | 15 | 0 | 0 |
| | | N-phenyl maleimide unit content *1 (%) | 16 | 16 | 0 | 0 | 16 | 0 | 0 |
| | Thickness (µm) | | 60 | 60 | 50 | 50 | 60 | 50 | 50 |
| Second resin layer | Second starting material composition (part) | Polyethylene terephthalate | 100 | | 100 | | 100 | 100 | |
| | | Polypropylene | | 100 | | 100 | | | 100 |
| | | Titanium oxide | 10 | 10 | 15 | 15 | 10 | 15 | 15 |
| | Content | Rubber content *1 (%) | 0 | 0 | 0 | 0 | 0 | 0 | 0 |
| | | N-phenyl maleimide unit content *1 (%) | 0 | 0 | 0 | 0 | 0 | 0 | 0 |
| | Thickness (µm) | | 100 | 100 | 50 | 50 | 100 | 50 | 50 |
| Back surface protective film for solar cell | | | | | | | | | |
| | Thickness (µm) | | 160 | 160 | 100 | 100 | 160 | 100 | 100 |
| | Evaluation | Peel strength (N) | 80 | 78 | 70 | 75 | 15 | 10 | 12 |
| | | State at peeling | 2 | 2 | 2 | 2 | 1 | 1 | 1 |
| | | L value *2 | 82 | 91 | 77 | 68 | 82 | 79 | 69 |
| | | Reflectance (wavelength:400-1400nm) *2 (%) | 75 | 73 | 73 | 75 | 78 | 74 | 73 |
| | | Retention rate of tensile strength (%) | 55 | 96 | 2 | 91 | 53 | 3 | 90 |
| | | Dimensional stability | 3 | 3 | 3 | 2 | 3 | 3 | 2 |
| | | Improvement rate of photoelectric conversion efficiency (%) | 19 | 18 | 17 | 18 | 19 | 17 | 16 |

*1 It is a content based on 100% by weight of a thermoplastic resin in each layer.
*2 It is a measured value at the surface of the first resin layer.

The following are apparent from the results in Table 2 and Table 3. Examples 2-2, 2-3, 2-7 and 2-8 adopting first thermoplastic resin compositions containing no silane coupling agents were high in peel strength and excellent as well in state at peeling, as compared to Comparative Examples 2-1, 2-2, 2-4 and 2-5 containing no silane coupling agents. Further, Examples 2-5 and 2-6 adopting first thermoplastic resin compositions containing no silane coupling agents were high in peel strength and excellent as well in state at peeling, as compared to Comparative Example 2-3 containing no silane coupling agents.

Examples 2-9 to 2-16 and Comparative Examples 2-6 to 2-10

Starting materials of compositions for forming first resin layers and second resin layers listed in Table 4 to Table

6 were used to obtain double-layer type back surface protective films for solar cell (black-white type) in the same manner as those in Example 2-1. Various evaluations were conducted for these back surface protective films for solar cell. The results are shown in Table 4 to Table 6.

Example 2-17

The first starting material composition for forming a first resin layer as listed in Table 5 was kneaded at a temperature of 250°C with Brabender kneader to prepare a first thermoplastic resin composition. Thereafter used was a T-die, to obtain a soft film (thickness: 170 μm) consisting of this first thermoplastic resin composition.
Subsequently, a resin layer forming film (F-1) was adhered onto a surface of the soft film with a polyurethane-based adhesive, to obtain a double-layer type back surface protective film for solar cell. Various evaluations were conducted for the back surface protective film for solar cell. The results are shown in Table 5.
[Table 4]

Table 4

| | | | Example | | | | Comparative Example | |
|---|---|---|---|---|---|---|---|---|
| | | | 2-9 | 2-10 | 2-11 | 2-12 | 2-6 | 2-7 |
| First resin layer | First starting material composition (part) | Acrylic rubber reinforced aromatic vinyl-based resin | 30 | 30 | 30 | | 30 | |
| | | Butadiene rubber reinforced aromatic vinyl-based resin | | | | 40 | | 40 |
| | | Acrylonitrile styrene copolymer | 30 | 30 | 30 | 20 | 30 | 20 |
| | | Acrylonitrile styrene N-phenyl maleimide copolymer | 40 | 40 | 40 | 40 | 40 | 40 |
| | | Silane coupling agent (x) | 8 | 3 | 0.3 | 3 | | |
| | | Perylene-based black pigment | 1 | 2 | 2 | 2 | 2 | 2 |
| | | Quinophthalone-based yellow pigment | 0.5 | 1 | 1 | 1 | 1 | 1 |
| | Content | Rubber content *1 (%) | 15 | 15 | 15 | 16 | 15 | 15 |
| | | N-phenyl maleimide unit content *1 (%) | 16 | 16 | 16 | 16 | 16 | 16 |
| | Thickness (µm) | | 200 | 60 | 40 | 60 | 60 | 60 |
| Second resin layer | Second starting material composition (part) | Acrylic rubber reinforced aromatic vinyl-based resin | 30 | 30 | 30 | | 30 | |
| | | Butadiene rubber reinforced aromatic vinyl-based resin | | | | 40 | | 40 |
| | | Acrylonitrile styrene copolymer | 30 | 30 | 30 | 20 | 30 | 20 |
| | | Acrylonitrile styrene N-phenyl maleimide copolymer | 40 | 40 | 40 | 40 | 40 | 40 |
| | | Titanium oxide | 20 | 20 | 20 | 20 | 20 | 20 |
| | Content | Rubber content *1 (%) | 15 | 15 | 15 | 16 | 15 | 15 |
| | | N-phenyl maleimide unit content *1 (%) | 16 | 16 | 16 | 16 | 16 | 16 |
| | Thickness (µm) | | 200 | 60 | 30 | 60 | 60 | 60 |
| Back surface protective film for solar cell | | | | | | | | |
| | Thickness (µm) | | 400 | 120 | 70 | 120 | 120 | 120 |
| | Evaluation | Peel strength (N) | 81 | 80 | 57 | 81 | 13 | 10 |
| | | State at peeling | 2 | 2 | 2 | 2 | 1 | 1 |
| | | L value *2 | 12 | 15 | 19 | 14 | 17 | 15 |
| | | Reflectance (wavelength:800-1400nm) *2 (%) | 75 | 70 | 65 | 71 | 72 | 75 |
| | | Transmittance (wavelength:800-1400nm) (%) | 80 | 87 | 88 | 85 | 88 | 86 |
| | | Absorbance (wavelength:400-700nm) (%) | 82 | 81 | 83 | 81 | 80 | 81 |
| | | Retention rate of tensile strength (%) | 98 | 97 | 98 | 97 | 99 | 94 |
| | | Dimensional stability | 3 | 3 | 3 | 3 | 3 | 3 |
| | | Improvement rate of photoelectric conversion efficiency (%) | 12 | 10 | 8 | 10 | 10 | 13 |

*1 It is a content based on 100% by weight of a thermoplastic resin in each layer.
*2 It is a measured value at the surface of the first resin layer.

[Table 5]

Table 5

| | | | | Example 2-13 | 2-14 | 2-15 | 2-16 | 2-17 |
|---|---|---|---|---|---|---|---|---|
| First resin layer | First starting material composition (part) | Acrylic rubber reinforced aromatic vinyl-based resin | | 30 | 30 | | | 30 |
| | | Acrylonitrile styrene copolymer | | 30 | 30 | | | 30 |
| | | Acrylonitrile styrene N-phenyl maleimide copolymer | | 40 | 40 | | | 40 |
| | | Polyethylene terephthalate | | | | 100 | | |
| | | Polypropylene | | | | | 100 | |
| | | Silane coupling agent (x) | | 3 | | | | 3 |
| | | Silane coupling agent (y) | | | 3 | 0.3 | | |
| | | Silane coupling agent (z) | | | | | 0.3 | |
| | | Perylene-based black pigment | | 2 | 2 | 2 | 2 | 1 |
| | | Quinophthalone-based yellow pigment | | 1 | 1 | 1 | 1 | 0.5 |
| | Content | Rubber content *1 | (%) | 15 | 15 | 0 | 0 | 15 |
| | | N-phenyl maleimide unit content *1 | (%) | 16 | 16 | 0 | 0 | 16 |
| | Thickness | | (μm) | 60 | 60 | 50 | 50 | 170 |
| Adhesive layer | Thickness | | (μm) | - | - | - | - | 8 |
| Second resin layer | Second starting material composition (part) | Polyethylene terephthalate | | 100 | | 100 | | |
| | | Polypropylene | | | 100 | | 100 | |
| | | Titanium oxide | | 10 | 10 | 15 | 15 | |
| | White PET film | | | | | | | F-1 |
| | Thickness | | (μm) | 100 | 100 | 50 | 50 | 50 |
| Back surface protective film for solar cell | Thickness | | (μm) | 160 | 160 | 100 | 100 | 228 |
| | Evaluation | Peel strength | (N) | 80 | 78 | 70 | 75 | 80 |
| | | State at peeling | | 2 | 2 | 2 | 2 | 2 |
| | | L value *2 | | 16 | 15 | 17 | 18 | 14 |
| | | Reflectance (wavelength:800-1400nm) *2 | (%) | 71 | 69 | 65 | 67 | 61 |
| | | Transmittance (wavelength:800-1400nm) | (%) | 84 | 86 | 88 | 85 | 80 |
| | | Absorbance (wavelength:400-700nm) | (%) | 80 | 80 | 79 | 80 | 82 |
| | | Retention rate of tensile strength | (%) | 55 | 96 | 2 | 91 | 93 |
| | | Dimensional stability | | 3 | 3 | 3 | 2 | 3 |
| | | Water vapor barrier property(g/($m^2$·day)) | | - | - | - | - | 8.2 |
| | | Improvement rate of photoelectric conversion efficiency | (%) | 11 | 9 | 8 | 9 | 9 |

*1 It is a content based on 100% by weight of a thermoplastic resin in each layer.
*2 It is a measured value at the surface of the first resin layer.

[Table 6]

Table 6

| | | | Comparative Example 2-8 | Comparative Example 2-9 | Comparative Example 2-10 |
|---|---|---|---|---|---|
| First resin layer | First starting material composition (part) | Acrylic rubber reinforced aromatic vinyl-based resin | 30 | | |
| | | Acrylonitrile styrene copolymer | 30 | | |
| | | Acrylonitrile styrene N-phenyl maleimide copolymer | 40 | | |
| | | Polyethylene terephthalate | | 100 | |
| | | Polypropylene | | | 100 |
| | | Perylene-based black pigment | 2 | 2 | 2 |
| | | Quinophthalone-based yellow pigment | 1 | 1 | 1 |
| | Content | Rubber content *1 (%) | 15 | 0 | 0 |
| | | N-phenyl maleimide unit content *1 (%) | 16 | 0 | 0 |
| | Thickness (μm) | | 60 | 50 | 50 |
| Second resin layer | Second starting material composition (part) | Polyethylene terephthalate | 100 | 100 | |
| | | Polypropylene | | | 100 |
| | | Titanium oxide | 10 | 15 | 15 |
| | Thickness (μm) | | 100 | 50 | 50 |
| Back surface protective film for solar cell | Thickness (μm) | | 160 | 100 | 100 |
| | Evaluation | Peel strength (N) | 15 | 10 | 12 |
| | | State at peeling | 1 | 1 | 1 |
| | | L value *2 | 15 | 16 | 18 |
| | | Reflectance (wavelength:800-1400nm) *2 (%) | 67 | 66 | 67 |
| | | Transmittance (wavelength:800-1400nm) (%) | 88 | 84 | 83 |
| | | Absorbance (wavelength:400-700nm) (%) | 81 | 82 | 82 |
| | | Retention rate of tensile strength (%) | 53 | 3 | 90 |
| | | Dimensional stability | 3 | 3 | 2 |
| | | Water vapor barrier property(g/(m2·day)) | - | - | - |
| | | Improvement rate of photoelectric conversion efficiency (%) | 8 | 8 | 8 |

*1 It is a content based on 100% by weight of a thermoplastic resin in each layer.

*2 It is a measured value at the surface of the first resin layer.

The following are apparent from the results in Table 4 to Table 6. Examples 2-10, 2-12, 2-15 and 2-16 adopting first thermoplastic resin compositions containing silane coupling agents were high in peel strength and excellent as well in state at peeling, as compared to Comparative Examples 2-6, 2-7, 2-9 and 2-10 containing no silane coupling agents. Further, Examples 2-13, 2-14 and 2-17 adopting first thermoplastic resin compositions containing silane coupling agents were high in peel strength and excellent as well in state at peeling, as compared to Comparative Example 2-8 containing no silane coupling agents.

3-3. Production and evaluation of multi-layer type back surface protective film for solar cell having water vapor barrier layer or the like

Example 3-1

The first starting material composition for forming a first resin layer as listed in Table 7 was kneaded at a temperature of 250°C with Brabender kneader to prepare a first thermoplastic resin composition. Thereafter used was a T-die, to obtain a soft film (thickness: 120 μm) consisting of this first thermoplastic resin composition.
Subsequently, a water vapor barrier layer forming film (R-1) shown in Table 7 was adhered with a polyurethane-based adhesive onto a surface of the soft film such that a vapor deposited film thereof was brought to an outer surface side, to obtain a back surface protective film for solar cell having a water vapor barrier layer. Various evaluations were conducted for the back surface protective film for solar cell. The results are shown in Table 7.

Examples 3-2 to 3-4 and 3-7 to 3-10

First starting material compositions for forming first resin layers listed in Table 7 and Table 8 were used to obtain soft films in the same manner as Example 3-1. Water vapor barrier layer forming films or (second) resin layer forming films listed in Table 7 and Table 8 were then adhered with a polyurethane-based adhesive onto surfaces of the soft films such that a vapor deposited film of the each water vapor barrier layer forming film was brought to an outer surface side, to obtain back surface protective films for solar cell having a water vapor barrier layer or a second resin layer. Various evaluations were conducted for the back surface protective film for solar cell. The results are shown in Table 7 and Table 8.

Example 3-5

The first starting material composition for forming a first resin layer as listed in Table 7 was kneaded at a temperature of 250°C with Brabender kneader to prepare a first thermoplastic resin composition. Thereafter used was a T-die, to obtain a soft film (thickness: 170 μm) consisting of this first thermoplastic resin composition.
Subsequently, a water vapor barrier layer forming film (R-1) shown in Table 7 was adhered with a polyurethane-based adhesive onto a surface of the soft film such that a vapor deposited film thereof was brought to an outer surface side. Further, a resin layer forming film (F-2) was adhered with a polyurethane-based adhesive onto a surface of the vapor deposited film of the water vapor barrier layer to obtain a back surface protective film for solar cell having a water vapor barrier layer and a second resin layer. Various evaluations were conducted for the back surface protective film for solar cell. The results are shown in Table 7.

Examples 3-6, 3-11 to 3-13

Materials listed in Table 7 and Table 8 were used to obtain back surface protective films for solar cell having a water vapor barrier layer and a second resin layer in the same manner as those in Example 3-5. Various evaluations were conducted for the back surface protective film for solar cell. The results are shown in Table 7 and Table 8.
[Table 7]

Table 7

| | | | Example | | | | | |
|---|---|---|---|---|---|---|---|---|
| | | | 3-1 | 3-2 | 3-3 | 3-4 | 3-5 | 3-6 |
| First resin layer | First starting material composition (part) | Acrylic rubber reinforced aromatic vinyl-based resin | 30 | 30 | 30 | 30 | 30 | 30 |
| | | Acrylonitrile styrene copolymer | 30 | 30 | 30 | 30 | 30 | 30 |
| | | Acrylonitrile styrene N-phenyl maleimide copolymer | 40 | 40 | 40 | 40 | 40 | 40 |
| | | Silane coupling agent (x) | 3 | 3 | 0.3 | 3 | 0.3 | 3 |
| | | Titanium oxide | 20 | 20 | 20 | 20 | 20 | 20 |
| | Content | Rubber content *1 (%) | 15 | 15 | 15 | 15 | 15 | 16 |
| | | N-phenyl maleimide unit content *1 (%) | 16 | 16 | 16 | 16 | 16 | 16 |
| | Thickness (μm) | | 120 | 70 | 150 | 200 | 170 | 150 |
| Adhesive layer | Thickness (μm) | | 5 | 8 | - | - | 10 | 10 |
| Water vapor barrier layer | Water vapor barrier layer forming film | | R-1 | R-2 | - | - | R-1 | R-1 |
| | Thickness (μm) | | 12 | 12 | - | - | 12 | 12 |
| Adhesive layer | Thickness (μm) | | - | - | 10 | 8 | 10 | 10 |
| Second resin layer | PET film | | - | - | F-2 | F-3 | F-2 | F-3 |
| | Thickness (μm) | | - | - | 50 | 75 | 50 | 75 |
| Back surface protective film for solar cell | Thickness (μm) | | 137 | 90 | 210 | 283 | 252 | 257 |
| | Evaluation | Peel strength (N) | 80 | 79 | 71 | 81 | 73 | 81 |
| | | State at peeling | 2 | 2 | 2 | 2 | 2 | 2 |
| | | L value *2 | 92 | 61 | 82 | 91 | 89 | 86 |
| | | Reflectance (wavelength:400-1400nm) *2 (%) | 70 | 60 | 75 | 78 | 78 | 75 |
| | | Retention rate of tensile strength (%) | 95 | 94 | 93 | 91 | 90 | 90 |
| | | Water vapor barrier layer property | 0.5 | 0.6 | 8.3 | 8.0 | 0.4 | 0.3 |
| | | Scratch resistance | - | - | 3 | 3 | 3 | 3 |
| | | Dimensional stability | 3 | 3 | 3 | 3 | 3 | 3 |

*1 It is a content based on 100% by weight of a thermoplastic resin in each layer.
*2 It is a measured value at the surface of the first resin layer.

[Table 8]

Table 8

| | | | Example | | | | | | |
|---|---|---|---|---|---|---|---|---|---|
| | | | 3-7 | 3-8 | 3-9 | 3-10 | 3-11 | 3-12 | 3-13 |
| First resin layer | First starting material composition (part) | Acrylic rubber reinforced aromatic vinyl-based resin | 30 | 30 | 30 | 30 | 30 | 30 | 30 |
| | | Acrylonitrile styrene copolymer | 30 | 30 | 30 | 30 | 30 | 30 | 30 |
| | | Acrylonitrile styrene N-phenyl maleimide copolymer | 40 | 40 | 40 | 40 | 40 | 40 | 40 |
| | | Silane coupling agent (x) | 0.3 | 3 | 3 | 3 | 3 | 3 | 3 |
| | | Perylene-based black pigment | 2 | 2 | 2 | 1 | 2 | 2 | 2 |
| | | Quinophthalone-based yellow pigment | 1 | 1 | 1 | 0.5 | 1 | 1 | 1 |
| | Content | Rubber content *1 (%) | 15 | 15 | 15 | 15 | 15 | 15 | 15 |
| | | N-phenyl maleimide unit content *1 (%) | 16 | 16 | 16 | 16 | 16 | 16 | 16 |
| | Thickness (μm) | | 35 | 120 | 150 | 170 | 170 | 170 | 170 |
| Adhesive layer | Thickness (μm) | | 10 | 5 | - | - | 10 | 10 | 10 |
| Water vapor barrier layer | Water vapor barrier layer forming film | | R-1 | R-2 | - | - | R-1 | R-1 | R-1 |
| | Thickness (μm) | | 12 | 12 | - | - | 12 | 12 | 12 |
| Adhesive layer | Thickness (μm) | | - | - | 10 | 8 | 10 | 10 | 10 |
| Second resin layer | PET film | | - | - | F-2 | F-3 | F-2 | F-3 | F-1 |
| | Thickness (μm) | | - | - | 50 | 75 | 50 | 75 | 50 |
| Back surface protective film for solar cell | Thickness (μm) | | 57 | 137 | 210 | 253 | 252 | 277 | 252 |
| | Evaluation | Peel strength (N) | 71 | 82 | 70 | 80 | 70 | 81 | 81 |
| | | State at peeling | 2 | 2 | 2 | 2 | 2 | 2 | 2 |
| | | L value *2 | 15 | 12 | 12 | 14 | 11 | 11 | 11 |
| | | Reflectance (wavelength:800-1400nm) *2 (%) | | | | | | | 50 |
| | | Transmittance (wavelength:800-1400nm) (%) | 82 | 80 | 81 | 80 | 79 | 81 | 80 |
| | | Absorbance (wavelength:400-700nm) (%) | 81 | 81 | 82 | 82 | 82 | 82 | 82 |
| | | Retention rate of tensile strength (%) | 96 | 95 | 91 | 93 | 90 | 90 | 90 |
| | | Water vapor barrier property (g/(m²·day)) | 0.6 | 0.5 | 7.5 | 7.2 | 0.3 | 0.4 | 0.4 |
| | | Scratch resistance | - | - | 3 | 3 | 3 | 3 | 3 |
| | | Dimensional stability | 3 | 3 | 3 | 3 | 3 | 3 | 3 |

*1 It is a content based on 100% by weight of a thermoplastic resin in each layer.

*2 It is a measured value at the surface of the first resin layer.

3-4. Production and evaluation of three-layer type back surface protective film for solar cell

Example 4-1

Henschel Mixer was used to prepare a first starting material composition, a second starting material composition and a third starting material composition for forming a first resin layer, a second resin layer and a third resin layer, respectively, as shown in Table 9. Thereafter, the compositions were each melted and kneaded with a twin-screw extruder (type name "TEX44" manufactured by The Japan Steel Works, LTD.) at a barrel temperature of 270°C, thereby obtaining three kinds of pellets constituting a first thermoplastic resin composition, a second thermoplastic resin composition and a third thermoplastic resin composition, respectively.
Subsequently, a multi-layer type film forming machine provided with three extruders each comprising a T-die having a die width of 1,400 mm and a lip distance of 1.5 mm, and a screw of 65 mm diameter was used, and the first thermoplastic resin composition, the second thermoplastic resin composition and the third thermoplastic resin composition were supplied to the extruders. Then, the molten resins were discharged from the T-dies at a temperature of 270°C, respectively, to form a three-layer type soft film. After that, this three-layer type soft film was cooled and solidified while being surface-contacted, by air knife, to a cast roll having a surface temperature controlled to be 95°C, to form a three-layer type back surface protective film for solar cell having a thickness of 800 μm in white color. The thickness of the first resin layer, second resin layer and third resin layer were shown in Table 9. The thickness of the film was measured with a thickness gauge (type name "ID-C1112C" manufactured by Mitutoyo Corp.) and was an average value of those measured values which was obtained by once cutting a film piece out of the produced film after a lapse of one hour from commencement of production thereof, and by measuring thicknesses of the film piece at its widthwise center and at points (n=107) at intervals of 10 mm from the widthwise center toward both edges. The values at measured points within a range of 20 mm from each edge of the film piece were excluded from the calculation of the average value.
Various evaluations were conducted for this back surface protective film for solar cell. The results are shown in Table 9.

Examples 4-2 to 4-4 and Comparative Examples 4-1 to 4-2

Starting materials of compositions for forming first resin layers, second resin layers and third resin layers listed in Table 9 were used to obtain three-layer type back surface protective films for solar cell in white color in the same manner as those in Example 4-1. Various evaluations were conducted for this back surface protective film for solar cell. The results are shown in Table 9.
[Table 9]

Table 9

| | | | Example | | | | Comparative Example | |
|---|---|---|---|---|---|---|---|---|
| | | | 4-1 | 4-2 | 4-3 | 4-4 | 4-1 | 4-2 |
| First resin layer | First starting material composition (part) | Acrylic rubber reinforced aromatic vinyl-based resin | 30 | 30 | 30 | | 30 | |
| | | Butadiene rubber reinforced aromatic vinyl-based resin | | | | 40 | | 40 |
| | | Acrylonitrile styrene copolymer | 30 | 30 | 30 | 20 | 30 | 20 |
| | | Acrylonitrile styrene N-phenyl maleimide copolymer | 40 | 40 | 40 | 40 | 40 | 40 |
| | | Silane coupling agent (x) | 0.3 | 3 | 8 | 3 | | |
| | | Titanium oxide | 20 | 20 | 15 | 20 | 20 | 15 |
| | Content | Rubber content *1 (%) | 15 | 15 | 15 | 16 | 15 | 16 |
| | | N-phenyl maleimide unit content *1 (%) | 16 | 16 | 16 | 16 | 16 | 16 |
| | Thickness (μm) | | 200 | 120 | 40 | 70 | 60 | 100 |
| Second resin layer | Second starting material composition (part) | Acrylic rubber reinforced aromatic vinyl-based resin | 30 | 30 | 20 | | 30 | 30 |
| | | Butadiene rubber reinforced aromatic vinyl-based resin | | | 10 | 38 | | |
| | | Acrylonitrile styrene copolymer | 8 | 8 | 8 | | 8 | 8 |
| | | Acrylonitrile styrene N-phenyl maleimide copolymer | 62 | 62 | 62 | 62 | 62 | 62 |
| | | Titanium oxide | | 20 | 15 | 20 | 20 | 15 |
| | Content | Rubber content *1 (%) | 15 | 15 | 14 | 15.2 | 15 | 15 |
| | | N-phenyl maleimide unit content *1 (%) | 24.8 | 24.8 | 24.8 | 24.8 | 24.8 | 24.8 |
| | Thickness (μm) | | 400 | 240 | 100 | 180 | 130 | 200 |
| Third resin layer | Third starting material composition (part) | Acrylic rubber reinforced aromatic vinyl-based resin | 30 | 30 | 30 | | 30 | |
| | | Butadiene rubber reinforced aromatic vinyl-based resin | | | | 40 | | 40 |
| | | Acrylonitrile styrene copolymer | 30 | 30 | 30 | 20 | 30 | 20 |
| | | Acrylonitrile styrene N-phenyl maleimide copolymer | 40 | 40 | 40 | 40 | 40 | 40 |
| | | Titanium oxide | 20 | 20 | 15 | 20 | 20 | 15 |
| | Content | Rubber content *1 (%) | 15 | 15 | 15 | 16 | 15 | 16 |
| | | N-phenyl maleimide unit content *1 (%) | 16 | 16 | 16 | 16 | 16 | 16 |
| | Thickness (μm) | | 200 | 120 | 40 | 70 | 60 | 100 |
| Back surface protective film for solar cell | | | | | | | | |
| | Thickness (μm) | | 800 | 480 | 180 | 320 | 250 | 400 |
| | Evaluation | Peel strength (N) | 67 | 75 | 82 | 71 | 12 | 15 |
| | | State at peeling | 2 | 2 | 2 | 2 | 1 | 1 |
| | | L value *2 | 93 | 92 | 85 | 90 | 89 | 90 |
| | | Reflectance (wavelength:400-1400nm) *2 (%) | 85 | 86 | 80 | 85 | 78 | 83 |
| | | Retention rate of tensile strength (%) | 99 | 97 | 98 | 94 | 99 | 94 |
| | | Dimensional stability | 3 | 3 | 3 | 3 | 3 | 3 |

*1 It is a content based on 100% by weight of a thermoplastic resin in each layer.
*2 It is a measured value at the surface of the first resin layer.

Apparent from the results in Table 9, the back surface protective films for solar cell according to Comparative Examples 4-1 and Comparative Example 4-2, having first resin layers adopting the first thermoplastic resin compositions containing no silane coupling agents therein were low in peel strength to be respectively 12 N and 15 N for adhesion to the film consisting of an ethylene vinyl acetate copolymer, and thus were insufficient in adhesiveness.
On the other hand, the back surface protective films for solar cell according to Examples 4-1 to 4-4, having first resin layers adopting the first thermoplastic resin compositions containing silane coupling agents blended therein were high in peel strength to be 67 to 82 N, and thus were excellent in adhesiveness.

Examples 4-5 to 4-6 and Comparative Examples 4-3 to 4-4

Starting materials of compositions for forming first resin layers, second resin layers and third resin layers listed in Table 10 were used to obtain three-layer type back surface protective films for solar cell in white color in the same manner as those in Example 4-1. Various evaluations were conducted for this back surface protective film for solar cell. The results are shown in Table 10.
[Table 10]

Table 10

| | | | Example | | Comparative Example | |
|---|---|---|---|---|---|---|
| | | | 4-5 | 4-6 | 4-3 | 4-4 |
| First resin layer | First starting composition (part) | Polyethylene terephthalate | 100 | | 100 | |
| | | Polypropylene | | 100 | | 100 |
| | | Silane coupling agent (y) | 0.3 | | | |
| | | Silane coupling agent (z) | | 0.3 | | |
| | | Titanium oxide | 15 | 15 | 15 | 15 |
| | Thickness (µm) | | 100 | 50 | 100 | 50 |
| Second resin layer | Second starting material composition (part) | Polyethylene terephthalate | 100 | | 100 | |
| | | Polypropylene | | 100 | | 100 |
| | | Titanium oxide | 15 | 15 | 15 | 15 |
| | Thickness (µm) | | 100 | 110 | 100 | 100 |
| Third resin layer | Third starting material composition (part) | Polyethylene terephthalate | 100 | | 100 | |
| | | Polypropylene | | 100 | | 100 |
| | | Titanium oxide | 15 | 15 | 15 | 15 |
| | Thickness (µm) | | 100 | 50 | 100 | 50 |
| Back surface protective film for solar cell | | | | | | |
| | Thickness (µm) | | 300 | 210 | 300 | 200 |
| | Evaluation | Peel strength (N) | 64 | 63 | 17 | 19 |
| | | State at peeling | 2 | 2 | 1 | 1 |
| | | L value *2 | 90 | 87 | 90 | 86 |
| | | Reflectance (wavelength:400-1400nm) *2 (%) | 83 | 80 | 82 | 79 |
| | | Retention rate of tensile strength (%) | 2 | 91 | 3 | 92 |
| | | Dimensional stability | 3 | 2 | 3 | 2 |

*2 It is a measured value at the surface of the first resin layer.

Apparent from the results in Table 10, the back surface protective films for solar cell according to Comparative

Examples 4-3 and Comparative Example 4-4, having first resin layers adopting the first thermoplastic resin compositions containing no silane coupling agents therein were low in peel strength to be respectively 17 N and 19 N for adhesion to the film consisting of an ethylene vinyl acetate copolymer, and thus were insufficient in adhesiveness.
On the other hand, the back surface protective films for solar cell according to Examples 4-5 and 4-6, having first resin layers adopting the first thermoplastic resin compositions containing silane coupling agents blended therein were high in peel strength to be 64 N and 63 N, and thus were excellent in adhesiveness.

Examples 4-7 to 4-8 and Comparative Example 4-5

Starting materials of compositions for forming first resin layers, second resin layers and third resin layers listed in Table 11 were used to obtain three-layer type back surface protective films for solar cell in the same manner as those in Example 4-1. Various evaluations were conducted for this back surface protective film for solar cell. The results are shown in Table 11.
[Table 11]

Table 11

| | | | Example 4-7 | Example 4-8 | Comparative Example 4-5 |
|---|---|---|---|---|---|
| First resin layer | First starting material composition (part) | Acrylic rubber reinforced aromatic vinyl-based resin | 30 | 30 | 30 |
| | | Acrylonitrile styrene copolymer | 30 | 30 | 30 |
| | | Acrylonitrile styrene N-phenyl maleimide copolymer | 40 | 40 | 40 |
| | | Silane coupling agent (x) | 0.3 | 0.3 | |
| | | Perylene-based black pigment | 2 | 1 | 2 |
| | | Quinophthalone-based yellow pigment | 1 | 0.5 | 1 |
| | Content | Rubber content *1 (%) | 15 | 15 | 15 |
| | | N-phenyl maleimide unit content *1 (%) | 16 | 16 | 16 |
| | Transmittance (wavelength:800-1400nm) (%) | | 82 | 89 | 81 |
| | Absorptivity (wavelength:400-700nm) (%) | | 81 | 72 | 80 |
| | Thickness (μm) | | 35 | 60 | 60 |
| Second resin layer | Second starting material composition (part) | Acrylic rubber reinforced aromatic vinyl-based resin | 30 | 20 | 20 |
| | | Butadiene rubber reinforced aromatic vinyl-based resin | | 10 | 10 |
| | | Acrylonitrile styrene copolymer | 8 | 8 | 8 |
| | | Acrylonitrile styrene N-phenyl maleimide copolymer | 62 | 62 | 62 |
| | | Titanium oxide | 10 | 15 | 15 |
| | Content | Rubber content *1 (%) | 15 | 14 | 14 |
| | | N-phenyl maleimide unit content *1 (%) | 24.8 | 24.8 | 24.8 |
| | Thickness (μm) | | 100 | 120 | 120 |
| Third resin layer | Third starting material composition (part) | Acrylic rubber reinforced aromatic vinyl-based resin | 30 | 30 | 30 |
| | | Acrylonitrile styrene copolymer | 30 | 30 | 30 |
| | | Acrylonitrile styrene N-phenyl maleimide copolymer | 40 | 40 | 40 |
| | | Titanium oxide | 20 | 15 | 20 |
| | Content | Rubber content *1 (%) | 15 | 15 | 15 |
| | | N-phenyl maleimide unit content *1 (%) | 16 | 16 | 16 |
| | Thickness (μm) | | 35 | 60 | 60 |
| Back surface protective film for solar cell | | | | | |
| | Thickness (μm) | | 170 | 240 | 240 |
| | Evaluation | Peel strength (N) | 71 | 77 | 15 |
| | | State at peeling | 2 | 2 | 1 |
| | | L value *2 | 19 | 21 | 16 |
| | | Reflectance (wavelength:400-1400nm) *2(%) | 60 | 65 | 66 |
| | | Retention rate of tensile strength (%) | 99 | 94 | 99 |
| | | Dimensional stability | 3 | 3 | 3 |

*1 It is a content based on 100% by weight of a thermoplastic resin in each layer.
*2 It is a measured value at the surface of the first resin layer.

Apparent from the results in Table 11, the back surface protective film for solar cell according to Comparative Examples 4-5, having a first resin layer adopting the first thermoplastic resin composition containing no silane coupling agents therein was low in peel strength to be 15 N for adhesion to the film consisting of an ethylene vinyl acetate copolymer, and thus was insufficient in adhesiveness.
On the other hand, the back surface protective films for solar cell according to Examples 4-7 and 4-8, having first resin layers adopting the first thermoplastic resin compositions containing silane coupling agents blended therein were high in peel strength to be 71 N and 77 N, and thus were excellent in adhesiveness.

3-5. Production and evaluation of multi-layer type back surface protective film for solar cell having water vapor barrier layer or the like

Example 5-1

A multi-layer type film forming machine provided with three extruders each comprising a T-die having a die width of 1,400 mm and a lip distance of 1.5 mm, and a screw of 65 mm diameter was used, and the first thermoplastic resin composition prepared using the first starting material composition, the second thermoplastic resin composition prepared using the second starting material composition and the third thermoplastic resin composition prepared using the third starting material composition were supplied to the extruders. Then, the molten resins were discharged from the T-dies at a temperature of 270°C, respectively, to form a three-layer type soft film. After that, this three-layer type soft film was cooled and solidified while being surface-contacted, by air knife, to a cast roll having a surface temperature controlled to be 95°C, to form a multi-layer type back surface protective film for solar cell having a thickness of 180 μm. The thickness of the first resin layer, second resin layer and third resin layer were shown in Table 12. The thickness of the film was measured with a thickness gauge (type name "ID-C1112C" manufactured by Mitutoyo Corp.) and was an average value of those measured values which was obtained by once cutting a film piece out of the produced film after a lapse of one hour from commencement of production thereof, and by measuring thicknesses of the film piece at its widthwise center and at points (n=107) at intervals of 10 mm from the widthwise center toward both edges. The values at measured points within a range of 20 mm from each edge of the film piece were excluded from the calculation of the average value.
Subsequently, a water vapor barrier layer forming film (R-1) was adhered with a polyurethane-based adhesive onto an outer surface of the third resin layer of the laminate type film such that a vapor deposited film thereof was brought to an outer surface side, to obtain a back surface protective film for solar cell. Various evaluations were conducted for the back surface protective film for solar cell. The results are shown in Table 12.

Example 5-2

The first starting material composition, second starting material composition and third starting material composition as well as a water vapor barrier layer forming film (R-2), shown in Table 12 were used in the same manner as those in Example 5-1 to obtain a back surface protective film for solar cell. Various evaluations were conducted for the back surface protective film for solar cell. The results are shown in Table 12.

Example 5-3

A multi-layer type film forming machine provided with three extruders each comprising a T-die having a die width of 1,400 mm and a lip distance of 1.5 mm, and a screw of 65 mm diameter was used, and the first thermoplastic resin composition prepared using the first starting material composition, the second thermoplastic resin composition prepared using the second starting material composition and the third thermoplastic resin composition prepared using the third starting material composition were supplied to the extruders. Then, the molten resins were discharged from the T-dies at a temperature of 270°C, respectively, to form a three-layer type soft film. After that, this three-layer type soft film was cooled and solidified while being surface-contacted, by air knife, to a cast roll having a surface temperature controlled to be 95°C, to form a multi-layer type back surface protective film for solar cell having a thickness of 180 μm. The thickness of the first resin layer, second resin layer and third resin layer were shown in Table 12. The thickness of the film was measured with a thickness gauge (type name "ID-C1112C" manufactured by Mitutoyo Corp.) and was an average value of those measured values which was obtained by once cutting a film piece out of the produced film after a lapse of one hour from commencement of production thereof, and by measuring thicknesses of the film piece at its widthwise center and at points (n=107) at intervals of 10 mm from the widthwise center toward both edges. The values at measured points within a range of 20 mm from each edge of the film piece were excluded from the calculation of the average value.
Subsequently, a resin layer forming film (F-2) was adhered with a polyurethane-based adhesive onto an outer surface

of the third resin layer of the laminate type film such that a vapor deposited film thereof was brought to an outer surface side, to obtain a four-layer type back surface protective film for solar cell. Various evaluations were conducted for the back surface protective film for solar cell. The results are shown in Table 12.

Example 5-4

The first starting material composition, second starting material composition and third starting material composition as well as resin layer forming film (F-3), shown in Table 12 were used in the same manner as those in Example 5-3 to obtain a four-layer type back surface protective film for solar cell. Various evaluations were conducted for the back surface protective film for solar cell. The results are shown in Table 12.

Example 5-5

A multi-layer type film forming machine provided with three extruders each comprising a T-die having a die width of 1,400 mm and a lip distance of 1.5 mm, and a screw of 65 mm diameter was used, and the first thermoplastic resin composition prepared using the first starting material composition, the second thermoplastic resin composition prepared using the second starting material composition and the third thermoplastic resin composition prepared using the third starting material composition were supplied to the extruders. Then, the molten resins were discharged from the T-dies at a temperature of 270°C, respectively, to form a three-layer type soft film. After that, this three-layer type soft film was cooled and solidified while being surface-contacted, by air knife, to a cast roll having a surface temperature controlled to be 95°C, to form a multi-layer type back surface protective film for solar cell having a thickness of 180 μm. The thickness of the first resin layer, second resin layer and third resin layer were shown in Table 12. The thickness of the film was measured with a thickness gauge (type name "ID-C1112C" manufactured by Mitutoyo Corp.) and was an average value of those measured values which was obtained by once cutting a film piece out of the produced film after a lapse of one hour from commencement of production thereof, and by measuring thicknesses of the film piece at its widthwise center and at points (n=107) at intervals of 10 mm from the widthwise center toward both edges. The values at measured points within a range of 20 mm from each edge of the film piece were excluded from the calculation of the average value.

Subsequently, a water vapor barrier layer forming film (R-1) was adhered with a polyurethane-based adhesive onto an outer surface of the third resin layer of the laminate type film such that a vapor deposited film thereof was brought to an outer surface side. Further, a resin layer forming film (F-2) was adhered with a polyurethane-based adhesive onto a surface of the vapor deposited film of the water vapor barrier layer to obtain a back surface protective film for solar cell. Various evaluations were conducted for the back surface protective film for solar cell. The results are shown in Table 12.

[Table 12]

Table 12

| | | | Example | | | | |
|---|---|---|---|---|---|---|---|
| | | | 5-1 | 5-2 | 5-3 | 5-4 | 5-5 |
| First resin layer | First starting material composition (part) | Acrylic rubber reinforced aromatic vinyl-based resin | 30 | 30 | 30 | 30 | 30 |
| | | Acrylonitrile styrene copolymer | 30 | 30 | 30 | 30 | 30 |
| | | Acrylonitrile styrene N-phenyl maleimide copolymer | 40 | 40 | 40 | 40 | 40 |
| | | Silane coupling agent (x) | 3 | 3 | 3 | 3 | 3 |
| | | Titanium oxide | 15 | 15 | 15 | 15 | 15 |
| | Content | Rubber content *1 (%) | 15 | 15 | 15 | 15 | 16 |
| | | N-phenyl maleimide unit content *1 (%) | 16 | 16 | 16 | 16 | 16 |
| | Thickness (μm) | | 40 | 40 | 40 | 40 | 40 |
| Second resin layer | Second starting material composition (part) | Acrylic rubber reinforced aromatic vinyl-based resin | 20 | 20 | 20 | 20 | 20 |
| | | Butadiene rubber reinforced aromatic vinyl-based resin | 10 | 10 | 10 | 10 | 10 |
| | | Acrylonitrile styrene copolymer | 8 | 8 | 8 | 8 | 8 |
| | | Acrylonitrile styrene N-phenyl maleimide copolymer | 62 | 62 | 62 | 62 | 62 |
| | | Titanium oxide | 15 | 15 | 15 | 15 | 15 |
| | Content | Rubber content *1 (%) | 14 | 14 | 14 | 14 | 14 |
| | | N-phenyl maleimide unit content *1 (%) | 24.8 | 24.8 | 24.8 | 24.8 | 24.8 |
| | Thickness (μm) | | 100 | 100 | 100 | 100 | 100 |
| Third resin layer | Third starting material composition (part) | Acrylic rubber reinforced aromatic vinyl-based resin | 30 | 30 | 30 | 30 | 30 |
| | | Acrylonitrile styrene copolymer | 30 | 30 | 30 | 30 | 30 |
| | | Acrylonitrile styrene N-phenyl maleimide copolymer | 40 | 40 | 40 | 40 | 40 |
| | | Titanium oxide | 15 | 15 | 15 | 15 | 15 |
| | Content | Rubber content *1 (%) | 15 | 15 | 15 | 15 | 15 |
| | | N-phenyl maleimide unit content *1 (%) | 16 | 16 | 16 | 16 | 16 |
| | Thickness (μm) | | 40 | 40 | 40 | 40 | 40 |
| Adhesive layer | Thickness (μm) | | 8 | 5 | - | - | 10 |
| Water vapor barrier layer | Water vapor barrier layer forming film | | R-1 | R-2 | - | - | R-1 |
| | Thickness (μm) | | 12 | 12 | - | - | 12 |
| Adhesive layer | Thickness (μm) | | - | - | 10 | 5 | 8 |
| Fourth resin layer | PET film | | - | - | F-2 | F-3 | F-2 |
| | Thickness (μm) | | - | - | 50 | 75 | 50 |
| Back surface protective film for solar cell | Thickness (μm) | | 200 | 197 | 240 | 260 | 260 |
| | Evaluation | Peel strength (N) | 76 | 75 | 75 | 77 | 78 |
| | | State at peeling | 2 | 2 | 2 | 2 | 2 |
| | | L value *2 | 61 | 61 | 61 | 61 | 61 |
| | | Reflectance (wavelength:400-1400nm) *2 (%) | 80 | 80 | 81 | 79 | 80 |
| | | Retention rate of tensile strength (%) | 95 | 96 | 91 | 99 | 99 |
| | | Scratch resistance | - | - | 3 | 3 | 3 |
| | | Dimensional stability | 3 | 3 | 3 | 3 | 3 |

*1 It is a content based on 100% by weight of a thermoplastic resin in each layer.
*2 It is a measured value at the surface of the first resin layer.

Apparent from the results in Table 12, Examples 5-1 and 5-2 were excellent in water vapor barrier property. Additionally, Examples 5-3 to 5-5 were excellent in scratch resistance.

Example 5-6

The first starting material composition, second starting material composition and third starting material composition as well as a water vapor barrier layer forming film (R-2), shown in Table 13 were used in the same manner as those in Example 5-1 to obtain a back surface protective film for solar cell. Various evaluations were conducted for the back surface protective film for solar cell. The results are shown in Table 13.

Example 5-7

The first starting material composition, second starting material composition and third starting material composition as well as a resin layer forming film (F-2), shown in Table 13 were used in the same manner as those in Example 5-1 to obtain a four layer type back surface protective film for solar cell. Various evaluations were conducted for the back surface protective film for solar cell. The results are shown in Table 13.

Example 5-8

The first starting material composition, second starting material composition and third starting material composition as well as a water vapor barrier layer forming film (R-1) and a resin layer forming film (F-3), shown in Table 13 were used in the same manner as those in Example 5-5 to obtain a back surface protective film for solar cell. Various evaluations were conducted for the back surface protective film for solar cell. The results are shown in Table 13.
[Table 13]

Table 13

| | | | Example | | |
|---|---|---|---|---|---|
| | | | 5-6 | 5-7 | 5-8 |
| First resin layer | First starting material composition (part) | Acrylic rubber reinforced aromatic vinyl-based resin | 30 | 30 | 30 |
| | | Acrylonitrile styrene copolymer | 30 | 30 | 30 |
| | | Acrylonitrile styrene N-phenyl maleimide copolymer | 40 | 40 | 40 |
| | | Silane coupling agent (x) | 0.3 | 0.3 | 0.3 |
| | | Perylene-based black pigment | 2 | 2 | 2 |
| | | Quinophthalone-based yellow pigment | 1 | 1 | 1 |
| | Content | Rubber content *1 (%) | 15 | 15 | 16 |
| | | N-phenyl maleimide unit content *1 (%) | 16 | 16 | 16 |
| | Thickness (μm) | | 35 | 35 | 35 |
| Second resin layer | Second starting composition (part) | Acrylic rubber reinforced aromatic vinyl-based resin | 30 | 30 | 30 |
| | | Acrylonitrile styrene copolymer | 8 | 8 | 8 |
| | | Acrylonitrile styrene N-phenyl maleimide copolymer | 62 | 62 | 62 |
| | | Titanium oxide | 10 | 10 | 10 |
| | Content | Rubber content *1 (%) | 15 | 15 | 15 |
| | | N-phenyl maleimide unit content *1 (%) | 24.8 | 24.8 | 24.8 |
| | Thickness (μm) | | 100 | 100 | 100 |
| Third resin layer | Third starting composition (part) | Acrylic rubber reinforced aromatic vinyl-based resin | 30 | 30 | 30 |
| | | Acrylonitrile styrene copolymer | 30 | 30 | 30 |
| | | Acrylonitrile styrene N-phenyl maleimide copolymer | 40 | 40 | 40 |
| | | Titanium oxide | 20 | 20 | 20 |
| | Content | Rubber content *1 (%) | 15 | 15 | 15 |
| | | N-phenyl maleimide unit content *1 (%) | 16 | 16 | 16 |
| | Thickness (μm) | | 35 | 35 | 35 |
| Adhesive layer | Thickness (μm) | | 8 | - | 8 |
| Water vapor barrier layer | Water vapor barrier layer forming film | | R-1 | - | R-1 |
| | Thickness (μm) | | 12 | - | 12 |
| Adhesive layer | Thickness (μm) | | - | 8 | 8 |
| Fourth resin layer | PET film | | - | F-2 | F-3 |
| | Thickness (μm) | | - | 50 | 75 |
| Back surface protective film for solar cell | Thickness (μm) | | 190 | 228 | 273 |
| | Evaluation | Peel strength (N) | 71 | 71 | 71 |
| | | State at peeling | 2 | 2 | 2 |
| | | L value *2 | 15 | 15 | 15 |
| | | Reflectance (wavelength:800-1400nm) *2 (%) | 60 | 61 | 60 |
| | | Transmittance (wavelength:800-1400nm) (%) | 82 | 82 | 82 |
| | | Absorbance (wavelength:400-700nm) (%) | 81 | 81 | 81 |
| | | Retention rate of tensile strength (%) | 95 | 91 | 90 |
| | | Scratch resistance | - | 3 | 3 |
| | | Dimensional stability | 3 | 3 | 3 |

*1 It is a content based on 100% by weight of a thermoplastic resin in each layer.
*2 It is a measured value at the surface of the first resin layer.

Apparent from the results in Table 13, Example 5-6 was excellent in water vapor barrier property. Additionally, Examples 5-7 and 5-8 were excellent in scratch resistance.

[Industrial Applicability]

The back surface protective film for solar cell of the present invention is excellent in adhesiveness to a filling unit which includes a solar cell unit containing an ethylene vinyl acetate copolymer composition or the like, and constitutes a solar cell module, heat resistance, and weathering resistance, as well as light reflectivity and design as a whole of the film. And it is thus useful as a back surface protective part for solar cell, naturally in a solar cell module constituting a solar cell to be used at a roof of a house or the like, and also in a solar cell module having flexibility.

[Explanations of numerals]

1, 1A, 1B, 1C, 1D, and 1E: back surface protective film for solar cell
11: first resin layer
15: other layer
151: metal layer
152: resin layer
153: resin layer
154: water vapor barrier layer
155: resin layer
2: solar cell module
21: obverse surface side transparent protective member
23: obverse surface side sealing film
25: solar cell element
27: reverse surface side sealing film

## Claims

1. A back surface protective film for solar cell, **characterized by** comprising a first resin layer obtained using a first thermoplastic resin composition which is prepared by melt-kneading a starting material composition containing a first thermoplastic resin and a silane coupling agent.

2. The back surface protective film for solar cell according to Claim 1, wherein said first thermoplastic resin comprises a rubber reinforced aromatic vinyl-based resin.

3. The back surface protective film for solar cell according to Claim 1 or 2, wherein said back surface protective film has a reflectance to a light having a wavelength of 400 to 1,400 nm of 50% or higher when said light is irradiated to a surface of said first resin layer of said back surface protective film for solar cell.

4. The back surface protective film for solar cell according to any one of Claims 1 to 3, wherein said first thermoplastic resin composition comprises further a white-based coloring agent.

5. The back surface protective film for solar cell according to Claim 1 or 2, wherein said first resin layer has a transmittance of a light having a wavelength of 800 to 1,400 nm of 60% or higher, and an absorbance of a light having a wavelength of 400 to 700 nm of 60% or higher.

6. The back surface protective film for solar cell according to Claim 1, 2 or 5, wherein said first thermoplastic resin composition comprises further an infrared transmissible coloring agent.

7. The back surface protective film for solar cell according to any one of Claims 1 to 6, further comprising other resin layer bonding to said first resin layer.

8. The back surface protective film for solar cell according to Claim 7, wherein at least one resin layer among said first resin layer and said other resin layer comprises a white-based coloring agent.

**9.** The back surface protective film for solar cell according to Claim 7, wherein said first resin layer has a transmittance of a light having a wavelength of 800 to 1,400 nm of 60% or higher, and an absorbance of a light having a wavelength of 400 to 700 nm of 60% or higher, and wherein said back surface protective film has a reflectance to a light having a wavelength of 800 to 1,400 nm of 50% or higher when said light is irradiated to a surface of said first resin layer of said back surface protective film for solar cell.

**10.** The back surface protective film for solar cell according to Claim 7 or 9, wherein said first resin layer comprises an infrared transmissible coloring agent, and wherein said other resin layer comprises a white-based coloring agent.

**11.** The back surface protective film for solar cell according to any one of Claims 7 to 10, wherein said other resin layer is consisting of two or more resin layers.

**12.** The back surface protective film for solar cell according to any one of Claims 1 to 11, having a thickness of 10 to 1,000 μm.

**13.** A solar cell module, **characterized by** comprising said back surface protective film for solar cell according to any one of Claims 1 to 12.

FIG. 1

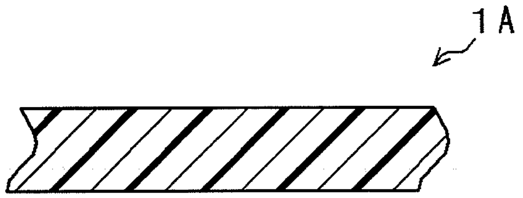


FIG. 2

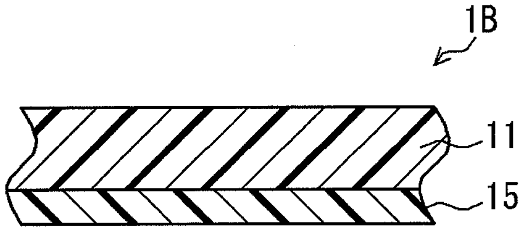


FIG. 3

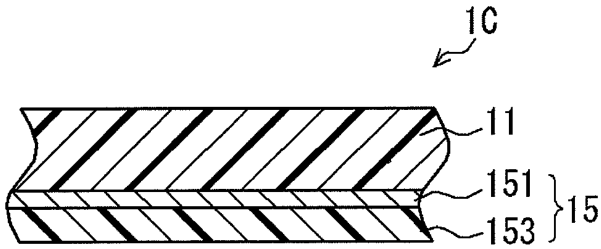


FIG. 4

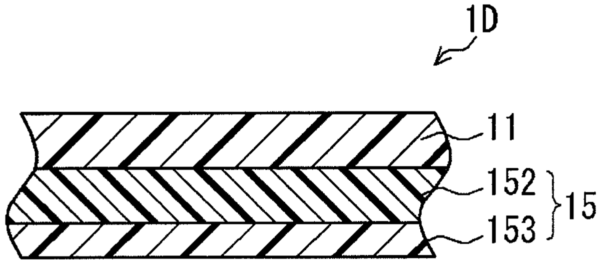

FIG. 5

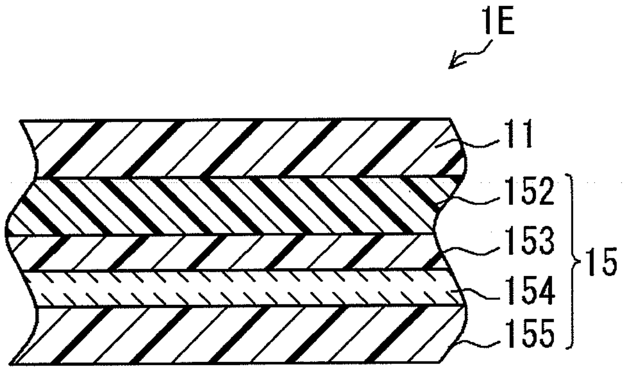


FIG. 6

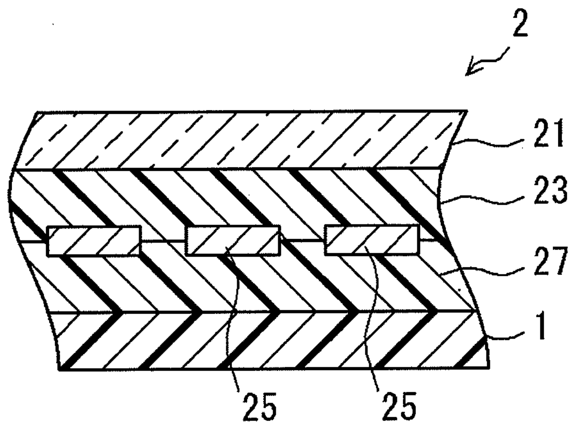

## INTERNATIONAL SEARCH REPORT

International application No.
PCT/JP2009/067268

A. CLASSIFICATION OF SUBJECT MATTER
*H01L31/042*(2006.01)i

According to International Patent Classification (IPC) or to both national classification and IPC

B. FIELDS SEARCHED

Minimum documentation searched (classification system followed by classification symbols)
H01L31/042

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br><br>Y | JP 2008-98592 A (Toyo Ink Manufacturing Co., Ltd.),<br>24 April 2008 (24.04.2008),<br>paragraphs [0073] to [0082]<br>(Family: none) | 1,2,4-8,<br>10-13<br>3,9 |
| Y | JP 2007-208179 A (Teijin DuPont Films Japan Ltd.),<br>16 August 2007 (16.08.2007),<br>claim 1<br>(Family: none) | 3,9 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 25 December, 2009 (25.12.09) | 12 January, 2010 (12.01.10) |
| Name and mailing address of the ISA/<br>Japanese Patent Office<br><br>Facsimile No. | Authorized officer<br><br><br>Telephone No. |

Form PCT/ISA/210 (second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2003060218 A
- JP 2006175764 A
- JP 2007268710 A
- JP S61233010 A
- JP S5993701 A
- JP A A
- JP S56167704 B